(19) Europäisches Patentamt / European Patent Office / Office européen des brevets

(11) **EP 3 846 225 A1**

(12) **EUROPEAN PATENT APPLICATION**
published in accordance with Art. 153(4) EPC

(43) Date of publication:
   **07.07.2021  Bulletin 2021/27**

(21) Application number: **19855111.1**

(22) Date of filing: **23.08.2019**

(51) Int Cl.:
   **H01L 29/786** (2006.01)   **G09F 9/30** (2006.01)
   **H01L 21/3205** (2006.01)   **H01L 21/336** (2006.01)
   **H01L 21/768** (2006.01)   **H01L 23/522** (2006.01)

(86) International application number:
   **PCT/JP2019/033100**

(87) International publication number:
   **WO 2020/045296 (05.03.2020 Gazette 2020/10)**

(84) Designated Contracting States:
   **AL AT BE BG CH CY CZ DE DK EE ES FI FR GB
   GR HR HU IE IS IT LI LT LU LV MC MK MT NL NO
   PL PT RO RS SE SI SK SM TR**
   Designated Extension States:
   **BA ME
   KH MA MD TN**

(30) Priority:  **30.08.2018  JP 2018161978**

(71) Applicant: **Toppan Printing Co., Ltd.**
   **Tokyo 110-0016 (JP)**

(72) Inventor: **ISHIZAKI, Mamoru**
   **Tokyo, 110-0016 (JP)**

(74) Representative: **Plasseraud IP**
   **66, rue de la Chaussée d'Antin**
   **75440 Paris Cedex 09 (FR)**

(54)   **THIN FILM TRANSISTOR ARRAY**

(57)   The present invention provides a thin film transistor array that is low in power consumption. The thin film transistor array includes: a column wiring and a row wiring; and a pixel including a thin film transistor. In the thin film transistor, a source electrode is in the shape of a line having a constant width in a plan view, a drain electrode includes a U-shaped part surrounding the source electrode with a gap having a predetermined length therebetween in the plan view, a semiconductor pattern is located at least between the source electrode and the drain electrode and forms a channel region, a gate electrode overlaps the channel region via a gate insulating film and includes the channel region in the plan view, and the source electrode is connected to the column wiring, the gate electrode is connected to the row wiring by a gate connecting wiring, and the drain electrode is connected to the pixel electrode by a drain connecting wiring.

FIG.1

EP 3 846 225 A1

**Description**

[Technical Field]

The present invention relates to thin film transistor arrays. The thin film transistor arrays according to the present invention can be used in display devices. Furthermore, the thin film transistor arrays according to the present invention are suitable for low power consumption applications.

[Background Art]

Transistors using semiconductor substrates, or amorphous silicon (a-Si) or polysilicon (poly-Si) thin film transistor (TFT) arrays using glass substrates based on integrated circuit technology have been produced for application to liquid crystal displays or other displays. TFTs serve as switches. Specifically, when a TFT is turned on by a selected voltage applied to a row wire (gate wire), a signal voltage provided to a column wire (source wire) is written into a pixel electrode connected to the drain electrode. The voltage written is held in a storage capacitor disposed between a capacitor electrode and the drain electrode or the pixel electrode. (In the case of TFT arrays, since the source and the drain are interchangeable depending on the polarity of a write voltage, the names "source" and "drain" cannot be assigned to electrodes based on operations thereof. Therefore, for the sake of convenience, one is described as "source" while the other is described as "drain". In the present invention, an electrode connected to a wire is termed a source, and one connected to a pixel electrode is termed a drain.)

In TFT arrays, there is a phenomenon called gate feedthrough in which a pixel potential changes upon switching of a gate potential from ON to OFF. The pixel potential changes due to a gate-feedthrough voltage $Vgf = \Delta Vg \cdot Cgd/(Cgd + Cs + Cp)$. Here, $\Delta Vg$ is an amount of change in the gate potential, $Cgd$ is a gate-drain capacitance, $Cs$ is a storage capacitance (capacitance between the pixel electrode and the capacitor), and $Cp$ is a capacitance due to a display medium. If $Cp$ is large, the storage capacitance $Cs$ can be omitted. If $Cp$ is small, $Cs$ becomes necessary, and if $Cp$ is much smaller than $Cs$, $Cp$ can be ignored. Conventionally, for the purpose of reducing the gate-feedthrough voltage, a device has been devised to reduce $Cgd$ (Patent Literature (PTL) 1). As shown in Fig. 21, the drain electrode is formed in the shape of a line having a constant width with a rounded tip, and the source electrode is formed in a U shape to surround the drain electrode, to make an area $Sgd$ of overlap between the gate electrode and the drain electrode small, making $Cgd$ small. Meanwhile, no importance has been given to gate-source capacitance $Cgs$.

In recent years, electronic paper display devices in which the thin film transistor array and an electrophoretic medium are combined have been developed and show promise as display devices that consume less power than liquid-crystal displays. This is because general liquid-crystal display devices can display data only while being driven and need to be continuously driven to keep the data displayed, whereas electrophoretic electronic paper keeps data displayed thereon even after driving ends and therefore does not need to be continuously driven.

Furthermore, the technique of combining electronic paper with radio-frequency identification (RFID), which is an identification technique, to form a display part of a container has been disclosed (PTL 2). By displaying the content stored in the RFID device on a display, the data can visually verified.

[Citation List]

[Patent Literature]

    [PTL 1] JP 2014-187093 A
    PTL 2: JP 2003-233786 A

[Summary of the Invention]

[Technical Problem]

Such displays can be categorized into a type rewriting data using power from an integral battery, and a type rewriting data by converting radio waves, from the reader/writer that rewrites data in the RFID device, into electric power and using the converted electric power. Either of these types has an issue of reducing power consumption during rewriting. In the case of displays incorporating batteries, the batteries are required to be frequently changed if power consumption is high. In displays using electric power from RF waves, if power consumption is high, rewriting can be performed only at short range over which radio signals are strong. Therefore, there is a demand for a thin film transistor array that consumes less power upon rewriting.

The present invention was conceived in view of such circumstances of the conventional art and has an object to provide a thin film transistor array with reduced power consumption.

[Solution to Problem]

One aspect of the present invention for solving the aforementioned problem is a thin film transistor array including: an insulating substrate; a plurality of column wirings extending in a first direction on the insulating substrate and a plurality of row wirings extending in a second direction that is perpendicular to the first direction; and a plurality of pixels disposed on the insulating substrate and each including a thin film transistor and a pixel electrode, the plurality of pixels corresponding to crossing points of the plurality of column wirings and the plurality of row wirings, wherein the thin film transistors including respective gate electrodes, source electrodes, drain electrodes and semiconductor patterns, the source electrode is in a shape of a line having a constant width in plan view, the drain electrode includes a U-shaped part in a U shape surrounding the source electrode with a gap having a predetermined width therebetween in the plan view, the semiconductor pattern forms a channel region at least between the source electrode and the drain electrode, the gate electrode overlaps the channel region via a gate insulating film and includes the channel region in the plan view, and the source electrode is connected to one of the plurality of column wirings, the gate electrode is connected to one of the plurality of row wirings by a gate connecting wiring, and the drain electrode is connected to the pixel electrode by a drain connecting wiring.

[Advantageous Effects of the Invention]

According to the present invention, a thin film transistor array having reduced power consumption can be provided. Specifically, using the present invention in displays enables a reduction in the power consumption during rewriting of the display device, enabling a reduction in the frequency of battery replacement for a display device of the type that includes an internal battery. Furthermore, the range at which displays of the type converting RF waves into electric power can be rewritten can be increased.

[Brief Description of the Drawings]

Fig. 1 includes plan views and cross-sectional views showing one example of a thin film transistor array according to a first embodiment of the present invention, during production.

Fig. 2 is a set of diagrams including plan views and cross-Sectional views showing one example of a thin film transistor array according to a modification, during production.

Fig. 3 includes plan views and cross-sectional views showing one example of a thin film transistor array according to a second embodiment of the present invention, during production.

Fig. 4 includes plan views and cross-sectional views showing one example of a thin film transistor array according to a modification, during production.

Fig. 5 includes plan views and cross-sectional views showing one example of a thin film transistor array according to a third embodiment of the present invention, during production.

Fig. 6A is a plan view showing a U-shaped part, a tip part, a U-shaped region, and an opening region.

Fig. 6B is a plan view showing the drain electrode.

Fig. 6C is a plan view showing the U-shaped part, the tip part, the U-shaped region, and the opening region.

Fig. 6D is a plan view showing the drain electrode.

Fig. 6E is a plan view showing the U-shaped part, the tip part, the U-shaped region, and the opening region.

Fig. 6F is a plan view showing the drain electrode.

Fig. 7A is an enlarged plan view of the thin film transistor shown in Fig. 1.

Fig. 7B is an enlarged plan view of a variation of the thin film transistor shown in Fig. 1.

Fig. 8 is an enlarged plan view of a thin film transistor shown in Fig. 3.

Fig. 9 is a plan view showing a source electrode and a source connecting wiring.

Fig. 10A includes plan views and cross-sectional views showing one example of a thin film transistor array according to a modification, during production.

Fig. 10B includes plan views and cross-sectional views showing a continuation of a manufacturing process shown in Fig. 10A.

Fig. 10C includes plan views and cross-sectional views showing a continuation of a manufacturing process shown in Fig. 10B.

Fig. 11A includes plan views and cross-sectional views showing one example of a thin film transistor array according to a modification, during production.

Fig. 11B includes plan views and cross-sectional views showing a continuation of a manufacturing process shown in Fig. 11A.

Fig. 11C includes plan views and cross-sectional views showing a continuation of a manufacturing process shown in Fig. 11B.

Fig. 12A includes plan views and cross-sectional views showing one example of a thin film transistor array according to a modification, during production.

Fig. 12B includes plan views and cross-sectional views showing a continuation of a manufacturing process shown in Fig. 12A.

Fig. 13A includes plan views and cross-sectional views showing one example of a thin film transistor array according to a variation that is in the middle of production.

Fig. 13B includes plan views and cross-sectional views showing a continuation of a manufacturing process shown in Fig. 13A.

Fig. 14A includes plan views and cross-sectional views showing one example of a thin film transistor array according to a modification, during production.

Fig. 14B includes plan views and cross-sectional views showing a continuation of a manufacturing process shown in Fig. 14A.

Fig. 14C includes plan views and cross-sectional views showing a continuation of a manufacturing process shown in Fig. 14B.

Fig. 15A includes plan views and cross-sectional views showing one example of a thin film transistor array according to a modification, during production.

Fig. 15B includes plan views and cross-sectional views showing a continuation of a manufacturing process shown in Fig. 15A.

Fig. 15C includes plan views and cross-sectional views showing a continuation of a manufacturing process shown in Fig. 15B.

Fig. 16A includes plan views and cross-sectional views showing one example of a thin film transistor array according to a modification, during production.

Fig. 16B includes plan views and cross-sectional views showing a continuation of a manufacturing process shown in Fig. 16A.

Fig. 16C includes plan views and cross-sectional views showing a continuation of a manufacturing process shown in Fig. 16B.

Fig. 17A includes plan views and cross-sectional views showing one example of a thin film transistor array according to a modification, during production.

Fig. 17B includes plan views and cross-sectional views showing a continuation of a manufacturing process shown in Fig. 17A.

Fig. 17C includes plan views and cross-sectional views showing a continuation of a manufacturing process shown in Fig. 17B.

Fig. 18 shows calculation of a voltage waveform, an electric current waveform, and an amount of electric power in a column wiring.

Fig. 19 shows calculation of a voltage waveform, an electric current waveform, and an amount of electric power in a row wiring.

Fig. 20 is a diagram illustrating calculation of a voltage waveform, an electric current waveform, and an amount of electric power in a pixel TFT.

Fig. 21 includes a plan view and a cross-sectional view showing one example of a conventional thin film transistor array.

[Description of the Embodiments]

Embodiments of the present invention will be described in detail hereinafter with reference to the drawings. Note that in the drawings used in the following, for simplicity of explanation, the scale is not shown accurately. The same or corresponding components in the embodiments and the variations are denoted by the same reference signs, and description thereof will be omitted.

(First Embodiment)

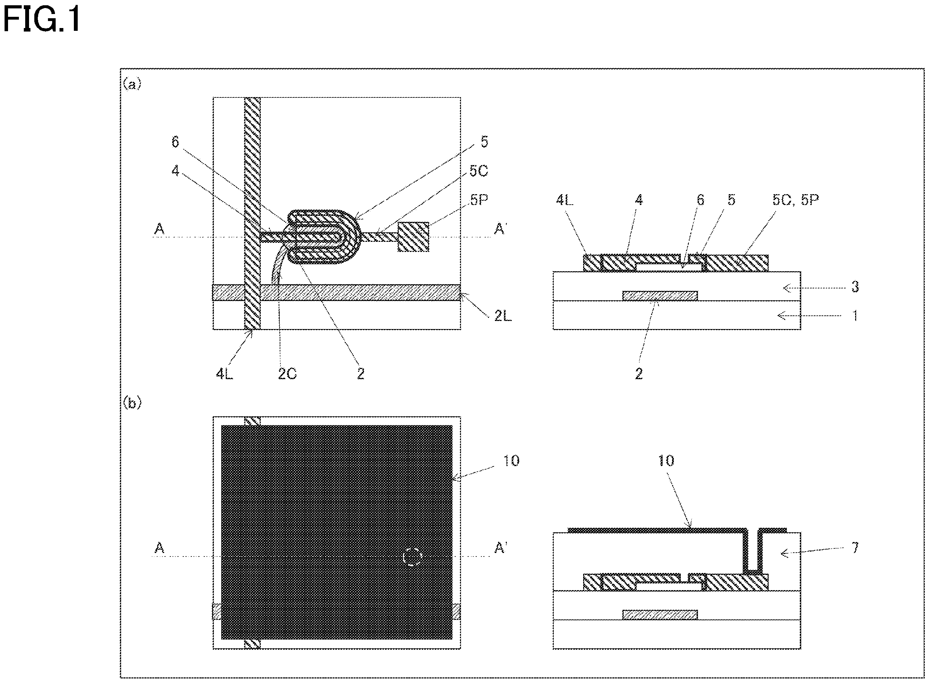

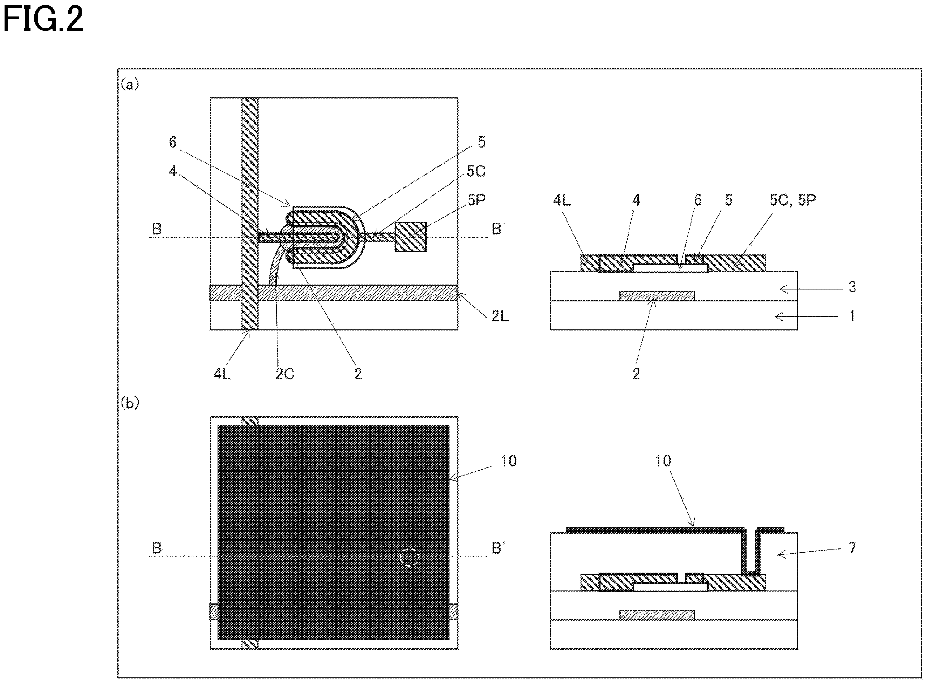

Fig. 1 shows a portion of a thin film transistor array according to a first embodiment of the present invention. Fig. 2 shows a portion of a thin film transistor array according to a modification thereof. In Figs. 1 and 2, (a) is a diagram during production for showing features in an easy-to-understand manner, and (b) is a final drawing. The thin film transistor array shown in Figs. 1 and 2 includes a plurality of column wirings 4L extending in the longitudinal direction (first direction), a plurality of row wirings 2L extending in the lateral direction (second direction) orthogonal to the plurality of column wirings 4L, and a plurality of pixels provided corresponding to crossing points of the column wirings 4L and the row wirings 2L.

Each pixel includes at least a thin film transistor and a pixel electrode 10. The thin film transistor includes a gate electrode 2, a source electrode 4, and a drain electrode 5. In a plan view, the source electrode 4 is in the shape of a line having a constant width, the drain electrode 5 includes a U-shaped part 5U in a U shape surrounding the source electrode 4 with a gap having a predetermined width therebetween, and at least a portion of a semiconductor pattern 6 connects the source electrode 4 and the drain electrode 5 to form a channel region 6C. The U shape is a shape resulting from connecting one tip of one of two parallel straight parts to one tip of the other. The portion connecting the tips (the bottom of the character U) may be straight or may be curved. The gate electrode 2 at least partially overlaps the channel region 6C via a gate insulating film 3, the source electrode 4 is connected to the column wiring 4L, the gate electrode 2 is connected to the row wiring 2L via a gate connecting wiring 2C, and the drain electrode 5 is connected to the pixel electrode 10 via at least a drain connecting wiring 5C.

In the case of Figs. 1 and 2, the tip of the source electrode 4 is rounded. Furthermore, the bottom of the U shape of the drain electrode 5 is also rounded. The straight parts of the U shape of the drain electrode 5 are distanced from the straight part of the source electrode 4 by a predetermined channel length, and the round bottom of the U shape of the drain electrode 5 is distanced from the rounded tip portion of the source electrode 4 by the predetermined channel length. With this structure, both side edges and the tip edge of the source electrode 4 can be used to form the channel region 6C, and the area of the source electrode 4 can be reduced while a channel width W for obtaining a required on-state current is sufficiently secured, and an area $S_{gs}$ of overlap between the gate electrode and the source electrode can be reduced, leading to a reduction in $C_{gs}$.

The gate connecting wiring 2C is narrower than the gate electrode 2 and overlaps neither of one of the drain electrodes 5 nor the drain connecting wiring 5C. Thus, gate-drain capacitance $C_{gd}$ can be minimized.

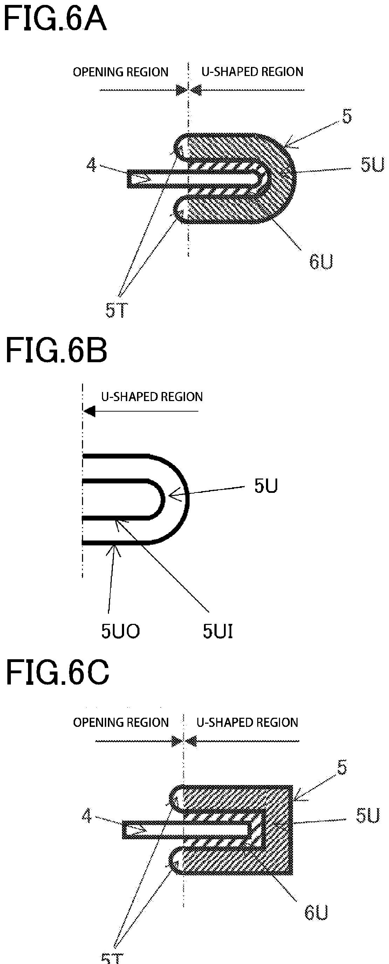

As shown in Fig. 6A, the drain electrode 5 includes a U-shaped part 5U proximate to the source electrode 4 at a predetermined distance (with a gap having a predetermined width) and two tip parts 5T extending away from the source electrode 4. The tip parts 5T may be rounded. Alternatively, the tip parts 5T may not be provided. The constant gap portion between the U-shaped part 5U of the drain electrode 5 and the source electrode 4 is a U-shaped region 6U of the channel. In Fig. 6A, the bottom of the U shape of the drain electrode 5 is rounded, is in the shape of a semicircle, and is concentric with the rounded tip of the source electrode 4, and the distance between the source electrode 4 and the drain electrode 5 (that is, the width of the U-shaped region 6U of the channel) is constant not only on both sides of the straight part of the source electrode 4, but also at the tip part of the source electrode 4. Therefore, this can function effectively as a transistor not only on both sides of the straight part of the source electrode 4, but also at the tip part of the source electrode 4. Note that regarding the phrase "the distance between the source electrode 4 and the drain electrode 5 (that is, the width of the U-shaped region 6U of the channel) is constant", it is sufficient that the distance be substantially constant; minor design differences or slight process-induced variations are within the scope of the present invention. For example, the tip of the source electrode 4 and the bottom of the U shape of the drain electrode 5 do not need to be perfectly concentric, and the center points thereof may be slightly displaced. Furthermore, the tip of the source electrode 4 and the round bottom of the U shape of the drain electrode 5 do not need to be exactly circular.

Fig. 6C is a variation of Fig. 6A. As shown in Fig. 6C, the drain electrode 5 includes a U-shaped part 5U proximate to the source electrode 4 at a predetermined distance therefrom (with a gap having a predetermined width) and two tip parts 5T extending away from the source electrode 4. The tip parts 5T of the drain electrode 5 may be rounded. Alternatively, the tip parts 5T may not be provided. The constant gap portion between the U-shaped part 5U of the drain electrode 5 and the source electrode 4 is a U-shaped region 6U of the channel. In Fig. 6C, at least a portion of the bottom of the U shape of the drain electrode 5 that faces the tip of the source electrode 4 is not rounded, the tip of the source electrode 4 is rectangular, and the distance between the source electrode 4 and the drain electrode 5 (that is, the width of the U-shaped region 6U of the channel) is constant not only on both sides of the straight part of the source electrode 4, but also on the side of the tip part of the source electrode 4. Therefore, this can function effectively as a transistor not only on both sides of the straight part of the source electrode 4, but also at the tip part of the source electrode 4. Note that regarding the phrase "the distance between the source electrode 4 and the drain electrode 5 (that is, the width of the U-shaped region 6U of the channel) is constant", it is sufficient that the distance be substantially constant; minor design differences or slight process-induced variations are within the scope of the present invention. Furthermore, a portion of the bottom of the U shape of the drain electrode 5 that does not face the tip part of the source electrode 4 may be rounded.

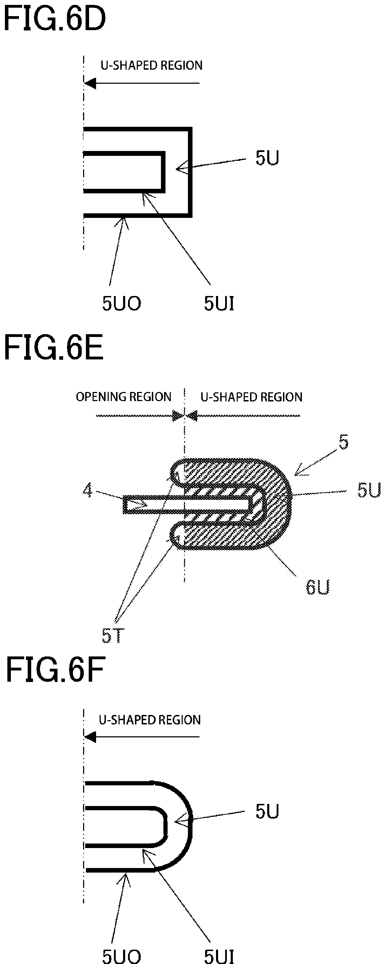

Fig. 6E is a special example of Fig. 6C. As shown in Fig. 6E, the drain electrode 5 includes a U-shaped part 5U proximate to the source electrode 4 at a predetermined distance (with a gap having a predetermined width) and two tip parts 5T extending away from the source electrode 4. The tip parts 5T of the drain electrode 5 may be rounded.

Alternatively, the tip parts 5T may not be provided. The constant gap portion between the U-shaped part 5U of the drain electrode 5 and the source electrode 4 is a U-shaped region 6U of the channel. In Fig. 6E, the bottom of the U shape of the drain electrode 5 is straight at the center, but round on both sides, the tip of the source electrode 4 is rectangular, the bottom edge of the rounded portion of the U shape of the drain electrode 5 matches a vertex of the source electrode 4, and the distance between the source electrode 4 and the drain electrode 5 (that is, the width of the U-shaped region 6U of the channel) is constant not only between both sides of the straight part of the source electrode 4 and the straight parts of the drain electrode 5, but also between the at the tip surface of the source electrode 4 and the straight part of the bottom of the U shape of the drain electrode 5 and between two vertices of the tip of the source electrode 4 and two rounded parts of the U shape of the drain electrode 5. Therefore, transistor functions are effective not only on both sides of the straight part of the source electrode 4, but also on at the tip part of the source electrode 4, and furthermore at the vertices of the source electrode 4. Note that regarding the phrase "the distance between the source electrode 4 and the drain electrode 5 (that is, the width of the U-shaped region 6U of the channel) is constant", it is sufficient that the distance be substantially constant; minor design differences or slight process-induced variations are within the scope of the present invention.

In Figs. 6A, 6C, and 6E, with respect to a straight line separating the U-shaped part 5U and the tip parts 5T of the drain electrode 5 as a boundary, the area on the U-shaped part 5U side is called a U-shaped region of the TFT, and the area on the side on which the U-shaped part 5U is open and the tip parts 5T are included is called an opening region of the TFT.

As shown in Figs. 6B, 6D, and 6F, the outer edge of the drain electrode 5 is an outer edge 5UO of the U-shaped part 5U, and the inner edge of the drain electrode 5 is an inner edge 5UI of the U-shaped part 5U.

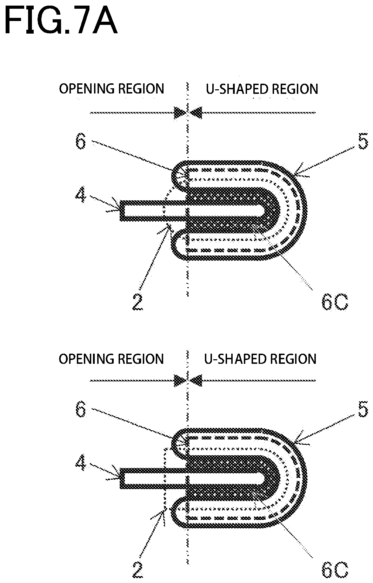

In Figs. 1 and 2, the contour of the gate electrode 2 is smaller than the outer edge 5UO of the drain electrode 5, but is larger than the inner edge 5UI of the drain electrode 5 in the U-shaped region in the plan view, as shown in Fig. 7A. In other words, at least a portion of the outline (the profile in plan view) of the gate electrode 2 is formed so as to overlap the U-shaped part 5U of the drain electrode 5 in the U-shaped region in the plan view. Since the contour of the gate electrode 2 is smaller than the outer edge 5UO of the drain electrode 5, the area Sgd of overlap between the gate electrode and the drain electrode is small, and the gate-drain capacitance Cgd is also small. Furthermore, since the contour of the gate electrode 2 is larger than the inner edge 5UI of the drain electrode 5, the current in the channel region 6C can be reliably controlled.

In (a) in Figs. 1 and 2, the outer profile of the gate electrode 2 is smaller than the contour of the semiconductor pattern 6 in the U-shaped region, the gate electrode 2 protrudes from the opening region, and the semiconductor pattern 6 does not protrude from the opening region in plan view, as shown in Fig. 7A. In other words, at least a portion of the outline of the gate electrode 2 overlaps the semiconductor pattern 6 in the U-shaped region and is formed outside the opening of the U-shaped part 5U, and at least a portion of the outline of the semiconductor pattern 6 is formed inside the opening of the U-shaped part 5U in plan view. As a result of the outline of the gate electrode 2 being smaller than the contour of the semiconductor pattern 6 in the U-shaped region, the area Sgd of overlap between the gate electrode and the drain electrode is small, and Cgd is also small. Furthermore, the gate electrode 2 protrudes from the opening region and the semiconductor pattern 6 does not protrude from the opening region, and thus the electric current in the channel region 6C can be reliably controlled. Note that a portion of the gate electrode 2 that protrudes from the opening region may be rounded as shown in the upper part of Fig. 7A or may be straight as shown in the lower part of Fig. 7A. The channel region 6C matches the U-shaped region 6U of the channel. In this case, Vg-Id characteristics may slightly change due to the effects of a parasitic transistor caused by the edge of the semiconductor pattern 6, but this causes no problem because driving of electronic paper does not require precise electric current control.

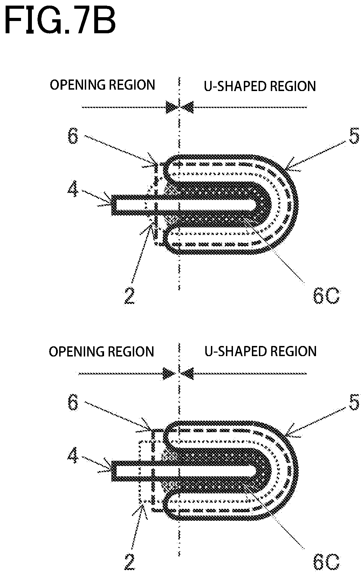

Alternatively, as shown in Fig. 7B, the contour of the gate electrode 2 may be smaller than the contour of the semiconductor pattern 6 in the U-shaped region, the gate electrode 2 may protrude from the opening region, and the semiconductor pattern 6 may protrude from the opening region, but a portion of the contour of the semiconductor pattern 6 may be formed inside the contour of the gate electrode 2 in the opening region in plan view. In other words, at least a portion of the outline of the gate electrode 2 overlaps the semiconductor pattern 6 in the U-shaped region and is formed outside the opening of the U-shaped part 5U of the drain electrode in the opening region, and at least a portion of the outline of the semiconductor pattern 6 is formed outside of the opening of the U-shaped part 5U and is formed inside the contour of the gate electrode 2 in plan view. As a result of the outline of the gate electrode 2 being smaller than the contour of the semiconductor pattern 6 in the U-shaped region, the area Sgd of overlap between the gate electrode and the drain electrode is small, and Cgd is also small. Furthermore, the gate electrode 2 protrudes from the opening region, and the semiconductor pattern 6 protrudes from the opening region, but is formed inside the contour of the gate electrode 2, and thus the electric current in the channel region 6C can be reliably controlled. Note that a portion of the gate electrode 2 that protrudes from the opening region may be round as shown in the upper part of Fig. 7B or may be straight as shown in the lower part of Fig. 7B. The channel region 6C is made up of two regions, namely, a main part including the U-shaped region 6U of the channel and an auxiliary part slightly protruding from the opening side.

In (a) in Fig. 1, the contour of the semiconductor pattern 6 is smaller than the outer edge 5UO of the drain electrode 5 in the U-shaped region in plan view. Therefore, the semiconductor pattern other than the channel region 6C can be entirely covered by the source electrode 4 and the drain electrode 5 in the U-shaped region, and when the TFT is covered by a capacitor electrode 8 to be described later, an area Sdc of overlap between the drain electrode 5 and the capacitor electrode 8 can be fixed, resulting in stabilization of characteristics. In Fig. 2, the contour of the semiconductor pattern 6 is larger than the outer edge 5UO of the drain electrode 5 in the U-shaped region in plan view. In this case, since there is the semiconductor pattern 6 around the drain electrode 5, the amount of objects to be etched at the time of etching the channel region 6C is large, which leads to the advantageous effect that the etching rate is equalized.

Note that (b) in Fig. 1 and (b) in Fig. 2 are examples in which there is no storage capacitance. When the display medium has large capacitance, charge is stored in the capacitance of the display medium and the electric potential is maintained, meaning that there is no need to provide storage capacitance inside the TFT array. This is the case, for example, when the display medium is liquid crystals and when the display medium is thin. In contrast, when the capacitance of the display medium is not sufficiently large, the storage capacitance Cs is used.

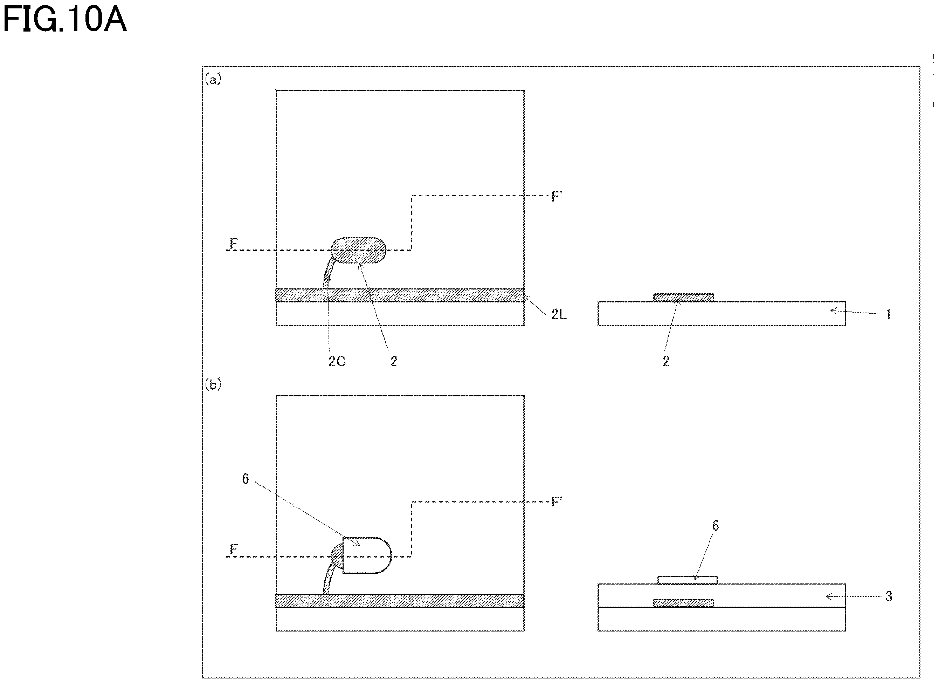

Figs. 10A to 13B show examples in which the storage capacitance Cs is provided. Figs. 10A to 10C show a manufacturing process of a thin film transistor array according to a variation in which a first conductive layer including the gate electrode 2 and the row wiring 2L, the gate insulating layer 3, a second conductive layer including the source electrode 4, the column wiring 4L, and the drain electrode 5, an interlayer insulating film 7, a third conductive layer including the capacitor electrode 8 and a capacitor wiring 8L, a capacitor insulating film 9, and a fourth conductive layer including the pixel electrode 10 are stacked at least in the stated order. Note that a specific manufacturing method will be described in an example to be described later.

In the manufactured thin film transistor array, the semiconductor pattern 6 is adjacent to the source electrode 4 and the drain electrode 5 and forms the U-shaped region 6U of the channel. Since the source electrode 4 is in the shape of a line having a constant width, the width of the source electrode 4 can be reduced almost to the limit of resolution, and as a result of the area of the source electrode 4 being small, the area Sgs of overlap between the gate electrode 2 and the source electrode 4 is small, and the gate-source capacitance Cgs is small. When the dielectric constant of the gate insulating film 3 is denoted as $\varepsilon gi$ and the thickness of the gate insulating film 3 is denoted as Dgi, $Cgs = \varepsilon gi \cdot Sgs/Dgi$. Note that the area Sgsl of overlap between the row wiring 2L and the column wiring 4L cannot be ignored and should be added, resulting in $Cgs = \varepsilon gi \cdot (Sgs + Sgsl)/Dgi$.

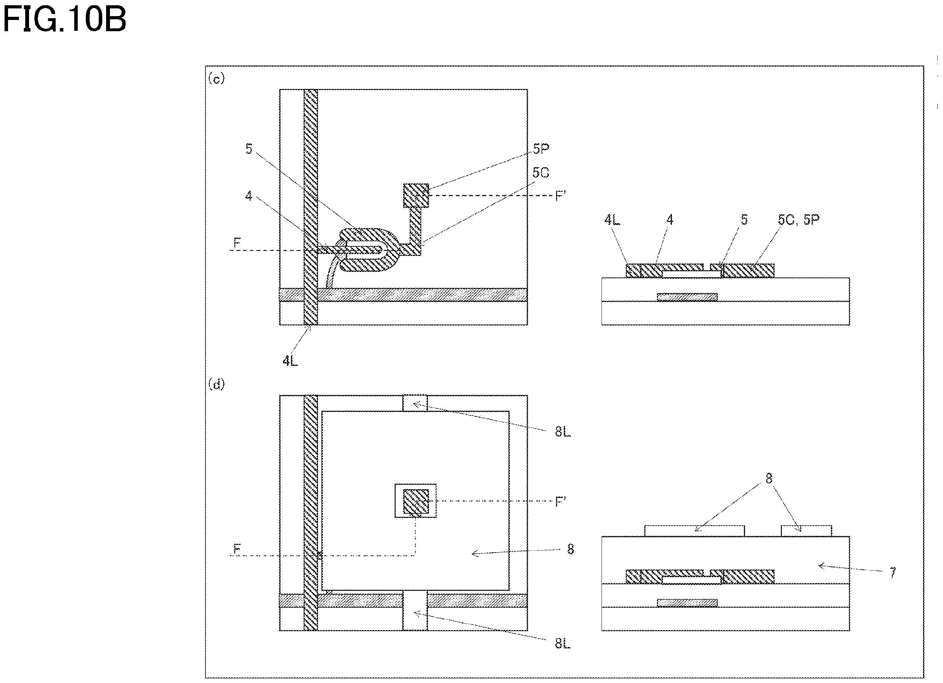

The column wiring 4L overlaps neither of the capacitor electrode 8 nor the capacitor wiring 8L in the plan view. Removing the overlap between the column wiring 4L and the capacitor electrode 8 can lead to a reduction in the source-capacitor capacitance Csc. When the TFT is covered by the capacitor electrode 8, since the source electrode 4 is in the shape of a line having a constant width, the width of the source electrode 4 can be reduced almost to the limit of resolution, and as a result of the area of the source electrode 4 being small, the area Ssc of overlap between the source electrode 4 and the capacitor electrode 8 is small, and the source-capacitor capacitance Csc is small. When the dielectric constant of the interlayer insulating film 7 is denoted as $\varepsilon il$ and the thickness of the interlayer insulating film 7 is denoted as Dil, $Csc = \varepsilon il \cdot Ssc/Dil$. (When the TFT is not covered by the capacitor electrode 8 as a variation of (d) in Fig. 10B, the area Ssc of overlap between the source electrode 4 and the capacitor electrode 8 is substantially zero, and the source-capacitor capacitance Csc is substantially zero.)

The pixel electrode 10 belongs to a layer different from a layer including the drain electrode 5, and there are the capacitor insulating film 9 and the interlayer insulating film 7 between the pixel electrode 10 and the drain electrode 5; thus, the drain electrode 5 is connected to the pixel electrode 10 via the drain connecting wiring 5C, a drain pad 5P, the opening of the interlayer insulating film 7, and the opening of the capacitor insulating film 9. A major part of the column wiring 4L desirably overlaps the pixel electrode 10 in plan view. When a major part of the column wiring 4L overlaps the pixel electrode 10, the electric potential at the column wiring 4L has no impact on the color of the display medium. Although capacitance Csp due to the overlap between the column wiring 4L and the pixel electrode 10 is generated, the capacitance Csp is not very large because two layers, the capacitor insulating film 9 and the interlayer insulating film 7, are sandwiched. When the dielectric constant of the capacitor insulating film 9 is denoted as $\varepsilon ci$ and the thickness of the capacitor insulating film 9 is denoted as Dci, $Csp = Ssp/(Dci/\varepsilon ci + Dil/\varepsilon il)$.

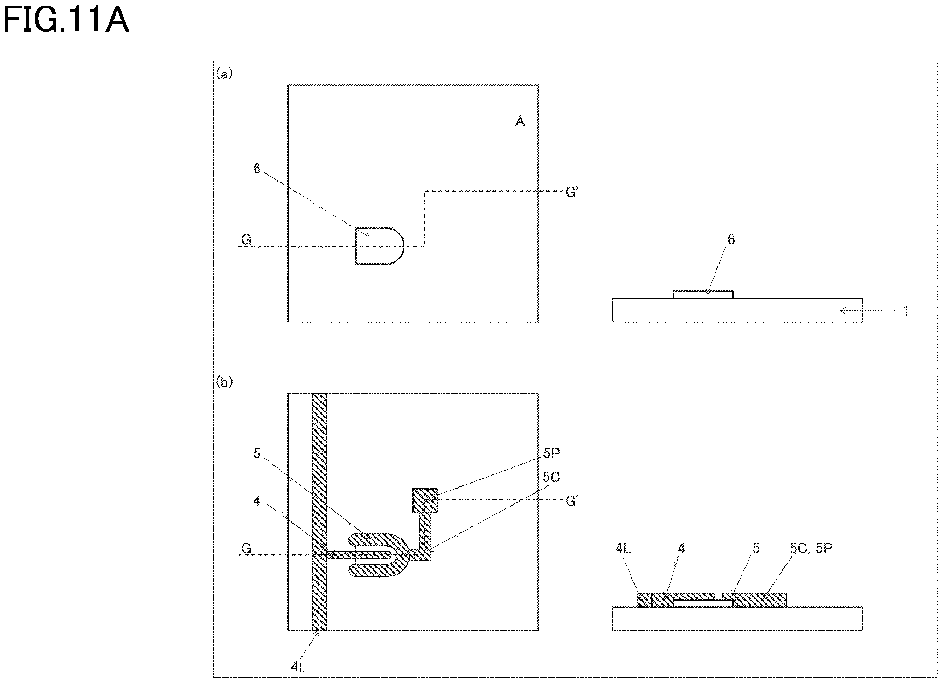

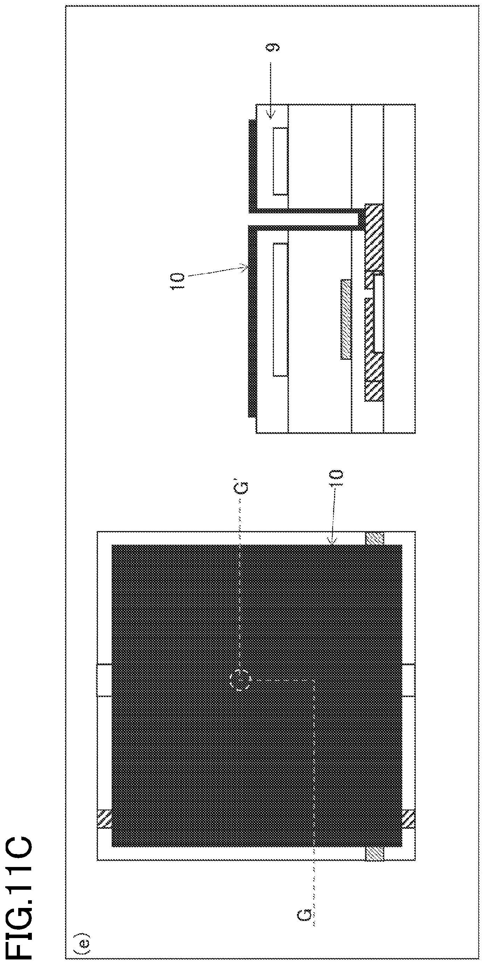

Figs. 11A to 11C show a manufacturing process of a thin film transistor array according to a variation in which a first conductive layer including the source electrode 4, the column wiring 4L, and the drain electrode 5, the gate insulating layer 3, a second conductive layer including the gate electrode 2 and the row wiring 2L, the interlayer insulating film 7, a third conductive layer including the capacitor electrode 8 and the capacitor wiring 8L, the capacitor insulating film 9, and a fourth conductive layer including the pixel electrode 10 are stacked at least in the stated order.

In the thin film transistor array in Figs. 11A to 11C, the gate-source capacitance Cgs is small as in Figs. 10A to 10C.

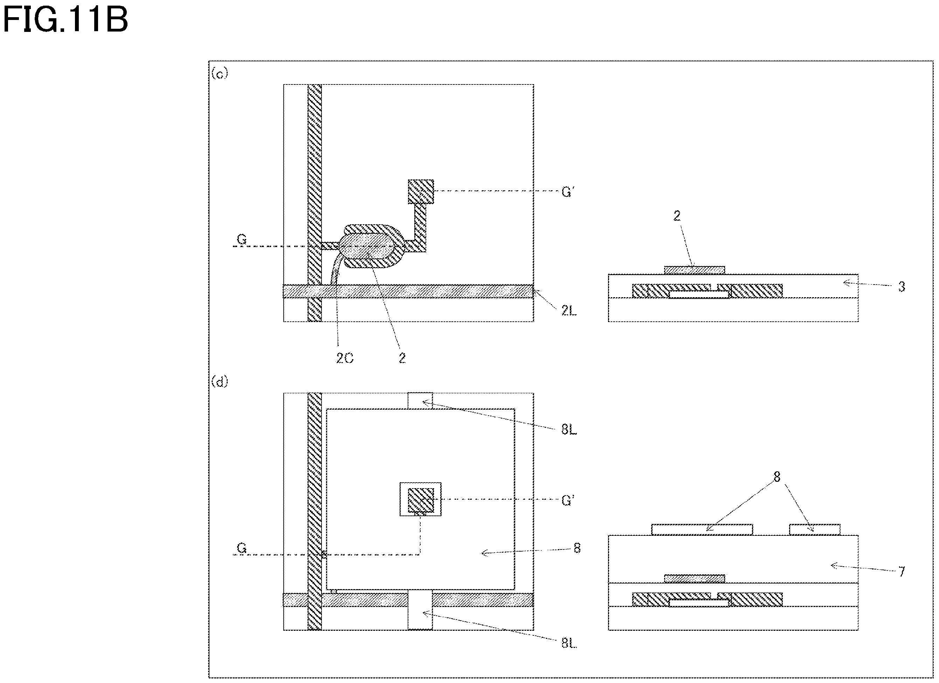

The column wiring 4L overlaps neither of the capacitor electrode 8 nor the capacitor wiring 8L in the plan view. Removing the overlap between the column wiring 4L and the capacitor electrode 8 can lead to a reduction in the source-capacitor capacitance Csc. Since a major part of the source electrode 4 is covered by the gate electrode 2, the area Ssc of overlap between the source electrode 4 and the capacitor electrode 8 is small, and the source-capacitor capacitance Csc is also small. When the dielectric constant of the interlayer insulating film 7 is denoted as $\varepsilon il$ and the thickness of the interlayer insulating film 7 is denoted as Dil, Csc = Ssc/(Dil/$\varepsilon il$ + Dgi/$\varepsilon gi$). When the TFT is covered by the capacitor electrode 8, an area Sgc of overlap between the gate electrode 2 and the capacitor electrode 8 is generated. When the dielectric constant of the interlayer insulating film 7 is denoted as $\varepsilon il$ and the thickness of the interlayer insulating film 7 is denoted as Dil, Cgc = $\varepsilon il \cdot Sgc/Dil$. (When the TFT is not covered by the capacitor electrode 8 as a variation shown by (d) in Fig. 11B, the area Sgc of overlap between the gate electrode 2 and the capacitor electrode 8 is substantially zero, but the area Sgcl of overlap between the row wiring 2L and the capacitor wiring 8L cannot be ignored; thus, the gate-capacitor capacitance Cgc is $\varepsilon il \cdot Sgcl/Dil$.)

The pixel electrode 10 belongs to a layer different from a layer to which the drain electrode 5 belongs, and there are the capacitor insulating film 9, the interlayer insulating film 7, the gate insulating film 3 between the pixel electrode 10 and the drain electrode 5; thus, the drain electrode 5 is connected to the pixel electrode 10 via the drain connecting wiring 5C, the drain pad 5P, the opening of the gate insulating film 3, the opening of the interlayer insulating film 7, and the opening of the capacitor insulating film 9. A major part of the column wiring 4L desirably overlaps the pixel electrode 10 in plan view. When a major part of the column wiring 4L overlaps the pixel electrode 10, the electric potential at the column wiring 4L has no impact on the color of the display medium. Although capacitance Csp due to the overlap between the column wiring 4L and the pixel electrode 10 is generated, the capacitance Csp is not very large because three layers, the capacitor insulating film 9, the interlayer insulating film 7, and the gate insulating film 3 are sandwiched. When the dielectric constant of the capacitor insulating film 9 is denoted as $\varepsilon ci$ and the thickness of the capacitor insulating film 9 is denoted as Dci, Csp = Ssp/(Dci/$\varepsilon ci$ + Dil/$\varepsilon il$ + Dgi/$\varepsilon gi$).

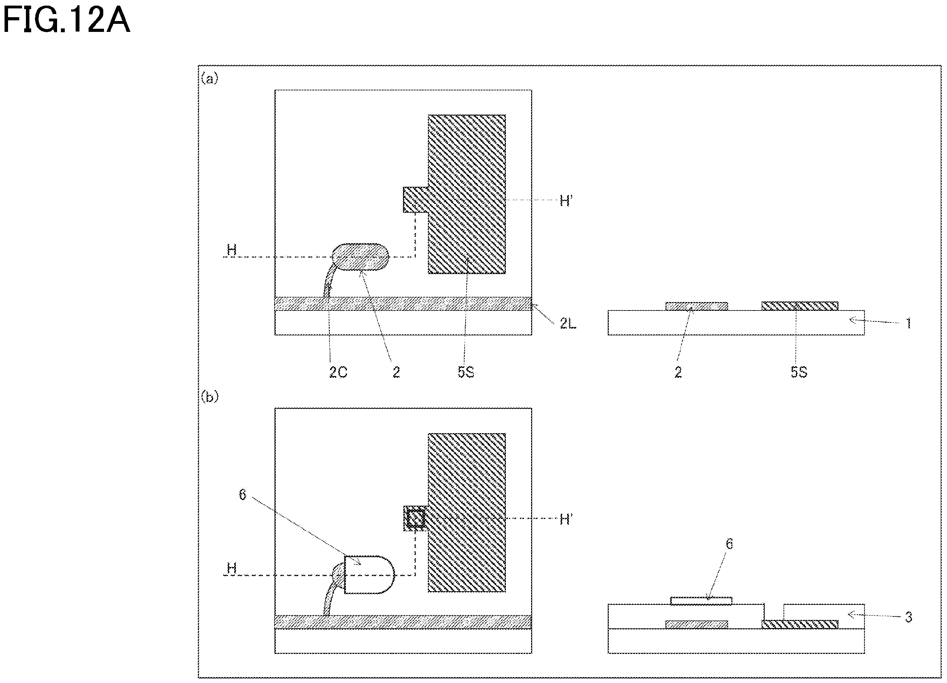

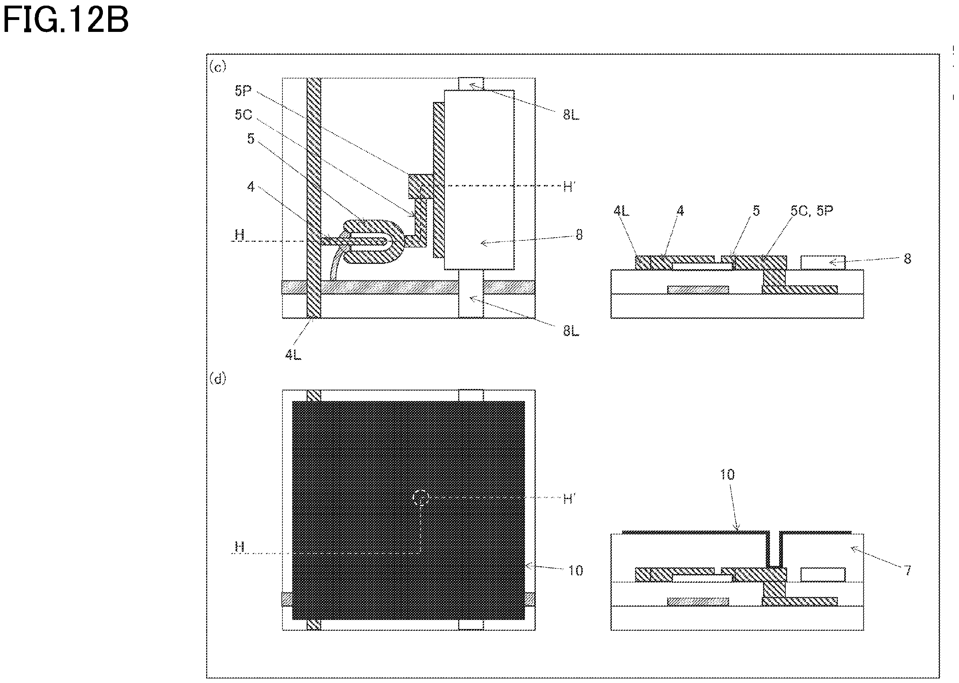

Figs. 12A and 12B show a manufacturing process of a thin film transistor array according to a variation in which a first conductive layer including the gate electrode 2, the row wiring 2L, and a drain sub-electrode 5S, the gate insulating film 3, a second conductive layer including the source electrode 4, the column wiring 4L, the drain electrode 5, the capacitor electrode 8, and the capacitor wiring 8L, the interlayer insulating film 7, and a third conductive layer including the pixel electrode 10 are stacked at least in the stated order.

In the thin film transistor array in Figs. 12A and 12B, the gate-source capacitance Cgs is small as in Figs. 10A to 10C.

The area of overlap between the column wiring 4L and the capacitor electrode 8 is zero, and the source-capacitor capacitance Csc is substantially zero. The pixel electrode 10 belongs to a layer different from a layer to which the drain electrode 5 belongs, and the interlayer insulating film 7 is located between the pixel electrode 10 and the drain electrode 5; thus, the drain electrode 5 is connected to the pixel electrode 10 via the drain connecting wiring 5C, the drain pad 5P, and the opening of the interlayer insulating film 7. A major part of the column wiring 4L desirably overlaps the pixel electrode 10 in plan view. When a major part of the column wiring 4L overlaps the pixel electrode 10, the electric potential at the column wiring 4L has no impact on the color of the display medium. Although capacitance Csp due to the overlap between the column wiring 4L and the pixel electrode 10 is generated, the capacitance Csp is not very large because the interlayer insulating film 7 is thick. Csp = $\varepsilon il \cdot Ssp/Dil$

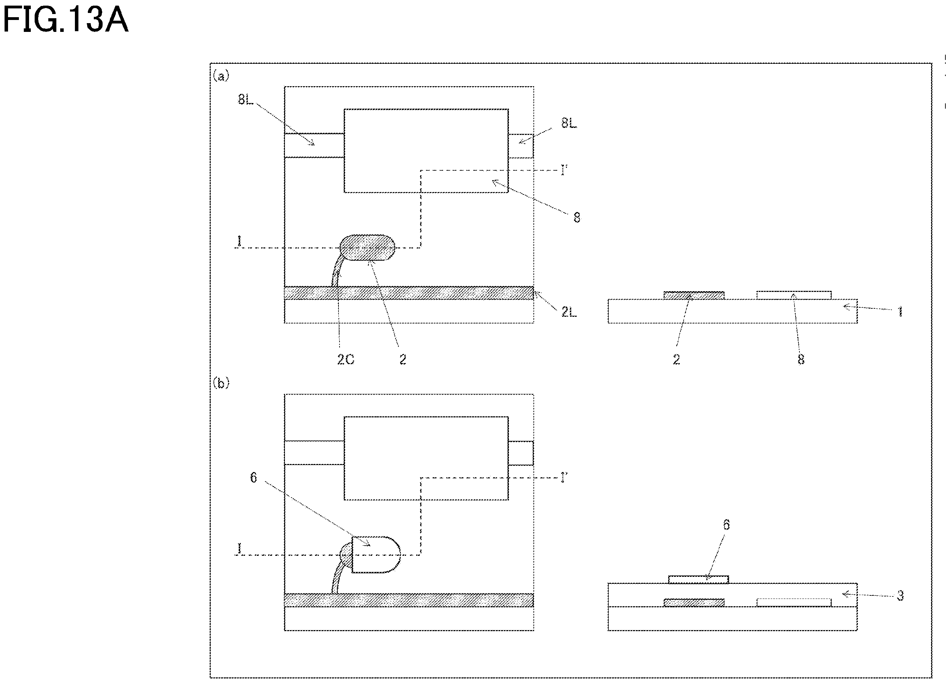

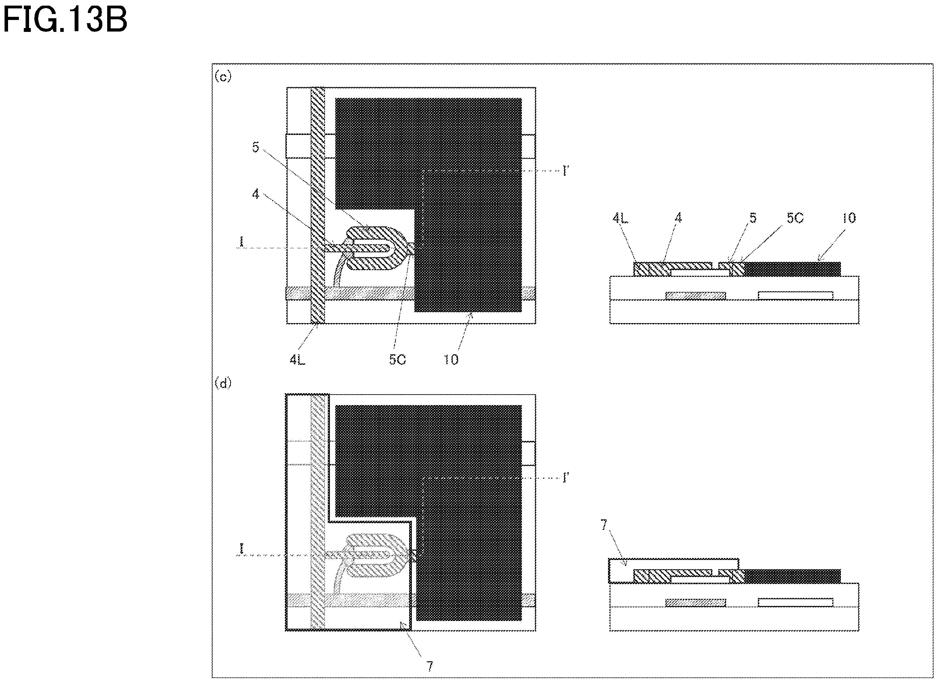

Figs. 13A and 13B show a manufacturing process of a thin film transistor array according to a variation in which a first conductive layer including the gate electrode 2, the row wiring 2L, the capacitor electrode 8, and the capacitor wiring 8L, the gate insulating film 3, a second conductive layer including the source electrode 4, the column wiring 4L, the drain electrode 5, and the pixel electrode 10, and the interlayer insulating film 7 are stacked at least in the stated order.

In the thin film transistor array in Figs. 13A and 13B, the gate-source capacitance Cgs is small as in Figs. 10A to 10C.

The source electrode 4 and the capacitor electrode 8 do not overlap each other, but the column wiring 4L and the capacitor wiring 8L have an area Sscl of overlap, and the source-capacitor capacitance is Csc = $\varepsilon il \cdot Sscl/Dgi$. The pixel electrode 10 is in the same layer as the drain electrode 5, and the drain electrode 5 is connected to the pixel electrode 10 via the drain connecting wiring 5C. The interlayer insulating film 7 covers at least the source electrode 4, the column wiring 4L, and the semiconductor pattern 6, and does not cover the pixel electrode 10. Since the column wiring 4L and the pixel electrode 10 are in the same layer, an area Ssp of overlap is zero, and source-pixel capacitance Csp is substantially zero.

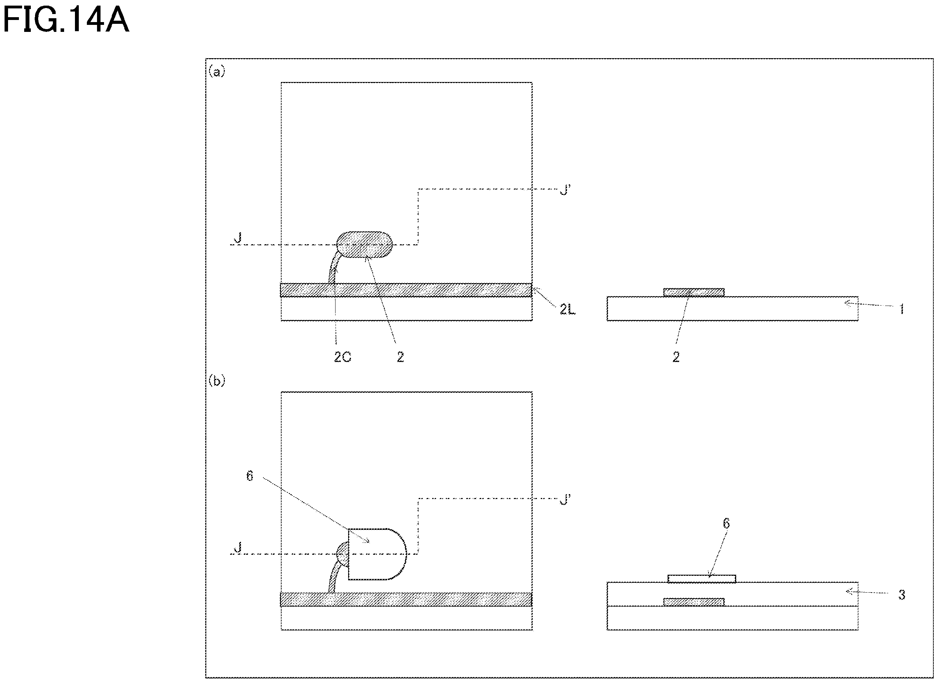

Figs. 14A to 14C are a variation of Fig. 2. Figs. 14A to 14C show a manufacturing process of a thin film transistor array according to a variation in which a first conductive layer including the gate electrode 2 and the row wiring 2L, the gate insulating layer 3, a second conductive layer including the source electrode 4, the column wiring 4L, and the drain electrode 5, the interlayer insulating film 7, a third conductive layer including the capacitor electrode 8 and the capacitor wiring 8L, the capacitor insulating film 9, and a fourth conductive layer including the pixel electrode 10 are stacked at least in the stated order.

In the thin film transistor array in Figs. 14A to 14C, the gate-source capacitance Cgs is small as in Figs. 10A to 10C.

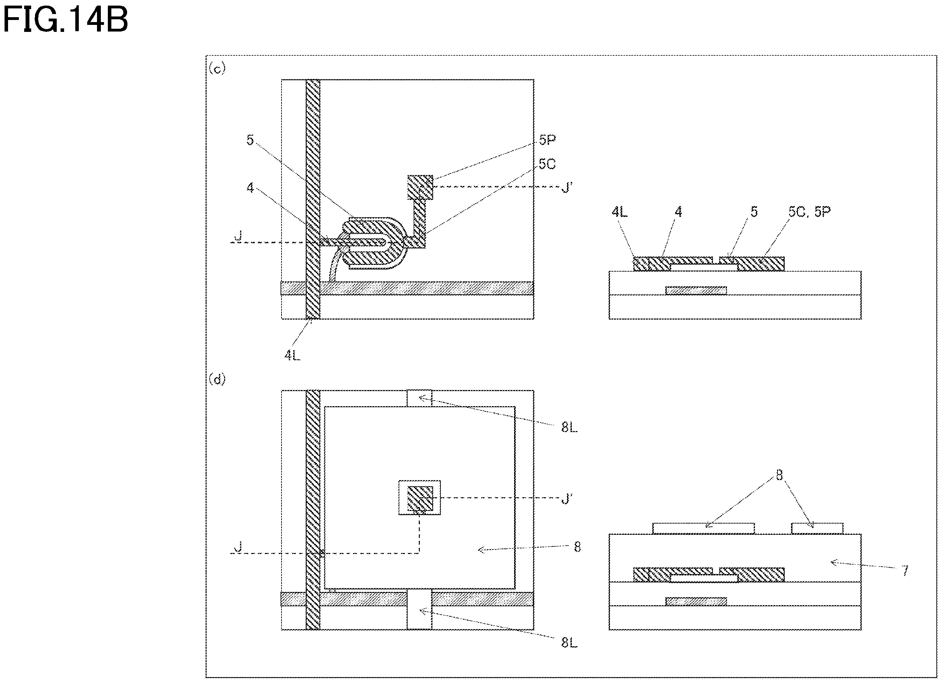

The column wiring 4L overlaps neither of the capacitor electrode 8 nor the capacitor wiring 8L in the plan view. Removing the overlap between the column wiring 4L and the capacitor electrode 8 can lead to a reduction in the source-capacitor capacitance Csc. When the TFT is covered by the capacitor electrode 8, since the source electrode 4 is in the shape of a line having a constant width, the width of the source electrode 4 can be reduced almost to the limit of resolution, the area Ssc of overlap between the source electrode 4 and the capacitor electrode 8 is small, and the source-capacitor capacitance Csc is small. When the dielectric constant of the interlayer insulating film 7 is denoted as $\varepsilon il$ and the thickness of the interlayer insulating film 7 is denoted as Dil, $Csc = \varepsilon il \cdot Ssc/Dil$. (When the TFT is not covered by the capacitor electrode 8 as a variation of (d) in Fig. 14B, the area Ssc of overlap between the source electrode 4 and the capacitor electrode 8 is substantially zero, and the source-capacitor capacitance Csc is substantially zero.)

The pixel electrode 10 belongs to a layer different from a layer including the drain electrode 5, and there are the capacitor insulating film 9 and the interlayer insulating film 7 between the pixel electrode 10 and the drain electrode 5; thus, the drain electrode 5 is connected to the pixel electrode 10 via the drain connecting wiring 5C, a drain pad 5P, the opening of the interlayer insulating film 7, and the opening of the capacitor insulating film 9. A major part of the column wiring 4L desirably overlaps the pixel electrode 10 in plan view. When a major part of the column wiring 4L overlaps the pixel electrode 10, the electric potential at the column wiring 4L has no impact on the color of the display medium. Although capacitance Csp due to the overlap between the column wiring 4L and the pixel electrode 10 is generated, the capacitance Csp is not very large because two layers, the capacitor insulating film 9 and the interlayer insulating film 7, are sandwiched. When the dielectric constant of the capacitor insulating film 9 is denoted as $\varepsilon ci$ and the thickness of the capacitor insulating film 9 is denoted as Dci, $Csp = Ssp/(Dci/\varepsilon ci + Dil/\varepsilon il)$.

Possible variations of Fig. 2 include a structure similar to those shown in Figs. 11A to 13B, which are variations of Fig. 1.

The importance of reducing Cgs, Csc, and Csp is described below. The TFT array includes five different electrodes, the gate electrode 2, the source electrode 4, the drain electrode 5, the capacitor electrode 8, and the pixel electrode 10, but since the pixel electrode 10 is connected to the drain electrode 5, the TFT array includes practically four different electrodes. Capacitance between these electrodes is of $_4C_2 = 6$ kinds, namely, Cgs, Csc, Csp, Cgd, Cgc, and Cs. The storage capacitance Cs is desirably large to some extent, but the other capacitances are desirably small.

Assume that there are M column wirings 4L and N row wirings 2L. In this case, Cgs, Csc, and Csp//Cs are connected to the column wirings 4L. Here, "//" means a series circuit of the capacitance; for example, $Csp//Cs = 1/(1/Csp + 1/Cs)$. Note that since $Csp \ll Cs$, $Csp//Cs \approx Csp$. There are N pixels connected to a single column wiring 4L, and therefore the capacitance is $C = N(Cgs + Csc + Csp//Cs)$.

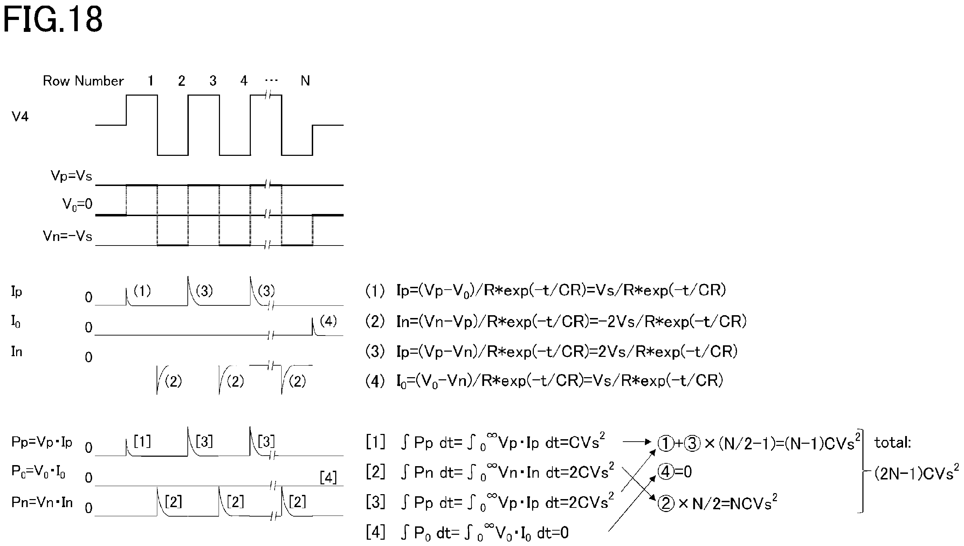

The column wiring 4L changes voltage according to data in each row and therefore, the amount of charge/discharge becomes largest when voltages having opposite polarities are written in respective adjacent rows. The amount of electric power consumed by a single column wiring 4L in a single frame can be calculated as indicated in Fig. 18. Here, the voltage waveform in the column wiring 4L is denoted as V4, voltages for white writing and black writing are denoted as $\pm Vs$, column wiring resistance (in a strict sense, the sum of column wiring resistance and series resistance (such as output resistance of a source driver)) is denoted as R. In Fig. 18, the horizontal axis denotes time t. At the source driver, the voltage and electric current of a positive power supply are denoted as Vp and Ip, respectively, the voltage and electric current of a negative power supply are denoted as Vn and In, respectively, and the voltage and electric current of a GND line are denoted as $V_0 = 0$ and $I_0$, respectively. The electric power consumed by the positive power supply is denoted as Pp, the electric power consumed by the negative power supply is denoted as Pn, and the electric power consumed by the GND line is $P_0 = 0$. The integral of each charging waveform is indicated as being evaluated in a range $t = 0$ to $\infty$ in order to simplify the equations, but it is sufficient that t be sufficiently larger than a time constant CR; for example, even if $t = 0$ to $3CR$, 95% of the amount of electric power is covered and approximately the same. The amount of electric power consumed by a single column wiring in a single frame is $(2N-1)C(Vs)^2$. Thus, the amount of electric power consumed by the M column wirings in a single frame is

$$M \times (2N - 1) \times N(Cgs + Csc + Csp//Cs) \times (Vs)^2 = MN(2N-1)\,(Cgs + Csc + Csp//Cs)\,(Vs)^2,$$

which can be regarded as $2M(N^2)\,(Cgs + Csc + Csp//Cs)(Vs)^2$ when N is sufficiently larger than 1. The amount of electric power consumption is smallest when the voltage at the column wiring remains the same; in this case, the amount of electric power consumed in a single frame is zero.

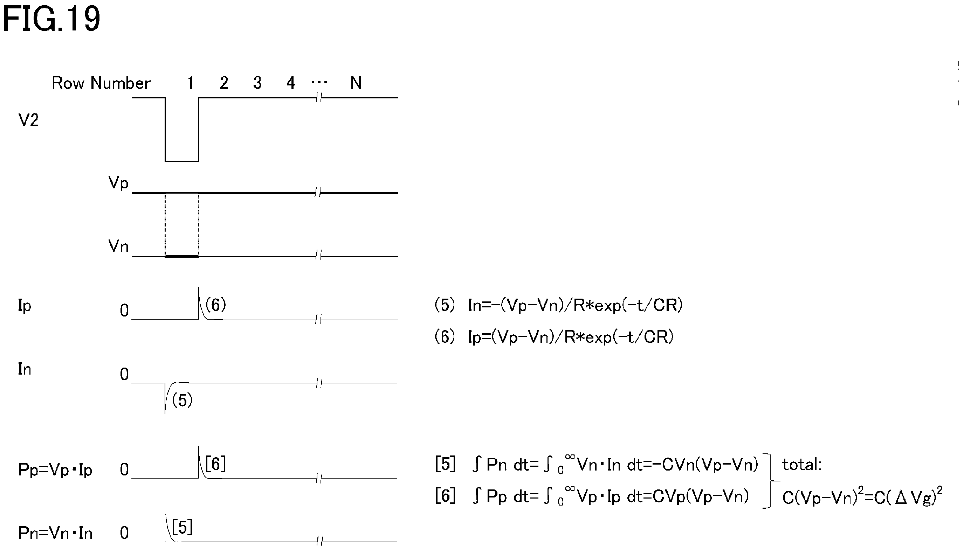

Here, Cgs, Cgc, and Cgd//Cs are connected to the row wirings 2L. There are M pixels connected to a single row wiring 2L, and therefore the capacitance is $C = M(Cgs + Cgc + Cgd//Cs)$. Note that since $Cgd \ll Cs$, $Cgd//Cs \approx Cgd$. In a single frame, the gate voltage changes twice in total, specifically once from OFF to ON and once from ON to OFF. When an amount of change in the gate voltage is denoted as $\Delta Vg$, the amount of electric power consumed by a single row wiring in a single frame can be calculated as shown in Fig. 19. The voltage waveform in the row wiring 2L is denoted as V2. Note that Fig. 19 shows the case of a p-channel TFT; in the case of an n-channel TFT, the equations for the amount of electric power consumption are the same although the plus/minus signs of the voltage are reversed. A positive voltage at the gate is denoted as Vp, a negative voltage at the gate is denoted as Vn, and row wiring resistance (in a strict sense, the sum of row wiring resistance and series resistance (such as output resistance of the gate driver)) is denoted as R. In Fig. 19, the horizontal axis denotes time t. At the gate driver 14, the voltage and electric current of a positive power supply are denoted as Vp and Ip, respectively, and the voltage and electric current of a negative power supply are denoted as Vn and In, respectively. The electric power consumed by the positive power supply is denoted as Pp, and the electric power consumed by the negative power supply is denoted as Pn. The integral of each charging waveform is indicated as being evaluated in a range $t = 0$ to $\infty$ in order to simplify the equations, but it is sufficient that t be sufficiently larger than a time constant CR; for example, even if $t = 0$ to 3CR, 95% of the amount of electric power is covered and approximately the same. The amount of electric power consumed by a single row wiring in a single frame is $C(\Delta Vg)^2$. The amount of electric power consumed by the N row wirings in a single frame is

$$N \times M(Cgs + Cgc + Cgd//Cs) \times (\Delta Vg)^2 = MN(Cgs + Cgc + Cgd//Cs)\,(\Delta Vg)^2.$$

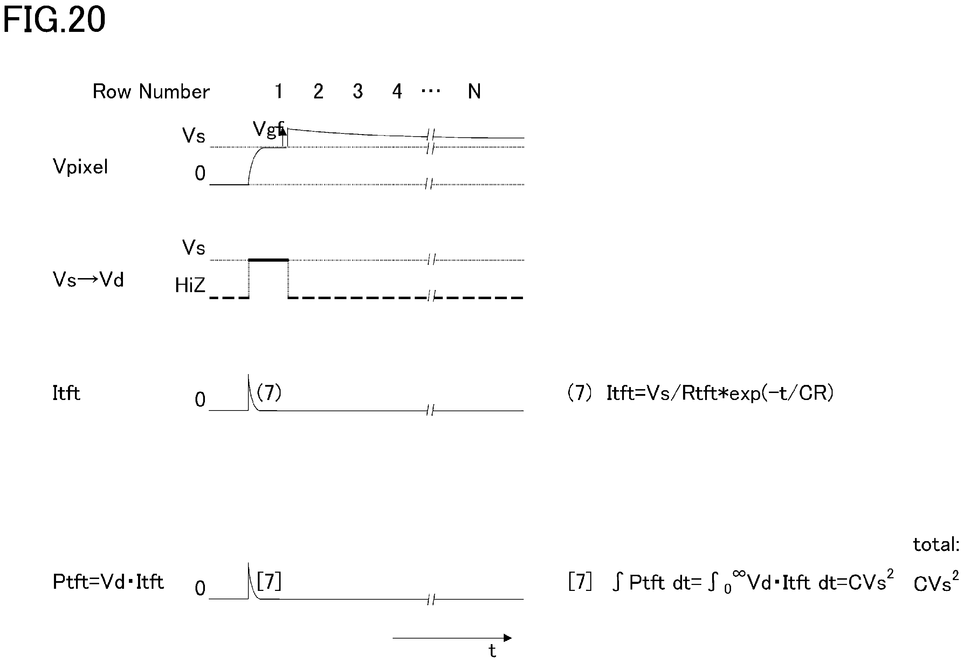

Here, Cgd and Cs are connected to the TFT. The capacitance is C = Cgd + Cs. In a single frame, the pixel voltage changes once when the pixel displays data different from previously displayed data. The amount of charging is largest in the case of changing data displayed at all the pixels. In this case, when an amount of change in the voltage in the column wiring is denoted as Vs, the amount of electric power consumed in a single frame can be calculated as shown in Fig. 20. The voltage waveform at the pixel is denoted as Vpixel. TFT resistance (in a strict sense, the sum of TFT resistance and series resistance (such as column wiring resistance)) is denoted as R. In Fig. 20, the horizontal axis denotes time t. When a drain voltage is written as Vd = Vs, the electric current is Itft and the electric power consumption is Ptft. The integral of the charging waveform is evaluated for the range $t = 0$ to $\infty$ in order to simplify the equations, but it is sufficient that t be sufficiently larger than the time constant CR; for example, even if $t = 0$ to 3CR, 95% of the amount of electric power is covered and approximately the same. The amount of electric power consumed by a single TFT in a single frame is $(Cs + Cgd)\,(Vs)^2$, and when there are MN TFTs, is $MN(Cs + Cgd)\,(Vs)^2$. In the case of Vd = -Vs, the same value is obtained. The amount of electric power consumption is smallest when the pixel potential remains the same; in this case, the amount of electric power consumed in a single frame is zero.

A coefficient of the amount of electric power consumed as described above is $MN^2$ for the column wiring, MN for the row wiring, and MN for the pixel. Normally, M, N, or the like is several tens to several hundreds. Furthermore, typically, Cgs, Csc, Csp, Cgc, and Cgd are smaller than Cs roughly by approximately two orders of magnitude. Thus, the maximum amount of electric power consumed by the column wiring in a single frame is substantially equal to the maximum amount of electric power consumed by the pixel in a single frame, and the amount of electric power consumed by the row wiring in a single frame is smaller than these by two orders of magnitude.

In the case of electronic paper, the same image is often drawn throughout two or more frames (approximately ten frames). In this case, electric power is consumed for rewriting in the first frame, but, in the second to the tenth frames, the electric potential is the same and therefore, almost no electric power is consumed. Thus, the maximum amount of electric power consumed by the column wiring in approximately ten frames is larger, and the maximum amount of electric power consumed by the pixel in approximately ten frames is smaller, by an order of magnitude, than the maximum amount of electric power consumed by the column wiring in approximately ten frames, and the maximum amount of electric power consumed by the row wiring in approximately ten frames is even smaller, by an order of magnitude, than the maximum amount of electric power consumed by the pixel in approximately ten frames. Therefore, reducing the capacitance (Cgs, Csc, Csp) connected to the column wiring is important for reducing the amount of electric power consumption.

Thus, the structures shown in Figs. 1, 2, and 10A to 14C have the advantageous effect of reducing the amount of electric power consumption. Specifically, using the above-described thin film transistor array in a display device enables a reduction in the power consumption upon rewriting of the display device, enabling a reduction in the frequency of battery replacement for a display device of a type that includes an internal battery. Furthermore, in the case of a display device of the type that converts RF waves into electric power, a possible rewrite range thereof can be extended.

Note that the width of the U-shaped part 5U of the drain electrode 5 may be, but is not required to be, constant. Although the inner edge 5UI needs to be in a U shape, the outer edge 5UO is not required to be in a U shape.

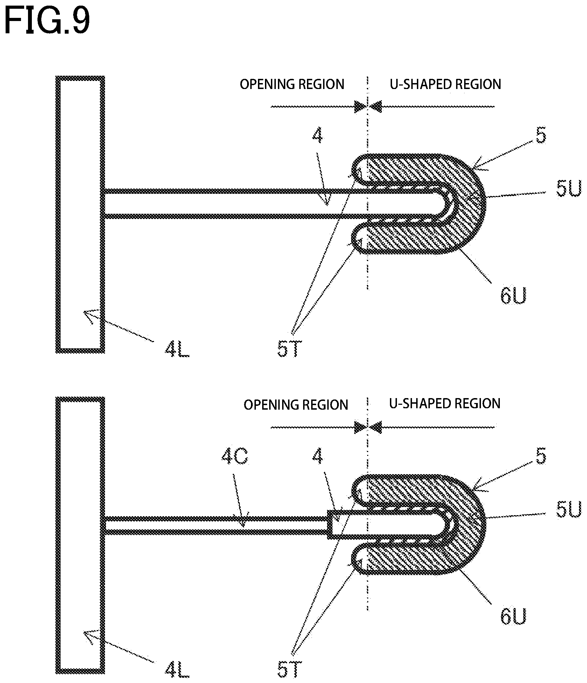

Furthermore, the width of the source electrode 4 is desirably less than or equal to the width of the column wiring 4L, as shown in Fig. 9. The area of the source electrode 4 has an impact on Cgs, and when the capacitor electrode 8 covers the source electrode 4, has an impact on Csc as well, resulting in a significant impact on the amount of electric power consumption in the column wiring. Therefore, the width of the source electrode 4 should be as small as possible. Meanwhile, the area of the column wiring 4L has an impact on Csp, but has a limited impact on the amount of electric power consumption in the column wiring because the insulating film relating to Csp is thick. The column wiring 4L is long and therefore electrical resistance thereof may cause a delay in signal response and deteriorate the display, and if the column wiring 4L is disconnected, all the subsequent pixels are affected. Therefore, the column wiring 4L may be broader than the source electrode 4.

Furthermore, instead of the source electrode 4 extending with a constant width and being directly connected to the column wiring 4L, a source connecting wiring 4C narrower than the source electrode 4 may connect the source electrode 4 and the column wiring 4L, as shown in the lower part of Fig. 9. Even in the case where the source electrode 4 cannot be made so narrow, Cgs, Csc, and the like can be reduced by reducing the width of the source connecting wiring 4C located between the TFT and the column wiring 4L.

Examples of the material of an insulating substrate 1 may include inorganic materials such as glass, and organic materials such as polyethylene terephthalate (PET), polyethylene naphthalate (PEN), polyether sulfone (PES), polycarbonate, polyimide (PI), polyether imide (PEI), polystyrene (PS), polyvinyl chloride (PVC), polyethylene (PE), polypropylene (PP), nylon (Ny), and epoxy.

Examples of the materials of the first conductive layer, the second conductive layer, the third conductive layer, and the fourth conductive layer may include metals such as Al, Ag, Cu, Cr, Ni, Mo, Au, Pt, and Nb, alloys thereof, conductive oxides such as ITO, carbon, and conductive polymers. The first conductive layer, the second conductive layer, the third conductive layer, and the fourth conductive layer may be formed by printing and baking an ink, or by forming a layer over the insulating substrate 1 by sputtering or the like and then performing photolithography, etching, and resist stripping. Alternatively, resist-printing, etching, and resist stripping may be performed after formation of the layer over the insulating substrate 1 by sputtering or the like, to form the first to the fourth conductive layers.

Examples of the materials of the gate insulating film 3, the interlayer insulating film 7, and the capacitor insulating film 9 may include inorganic materials such as $SiO_2$, SiON, and SiN, and organic materials such as polyvinyl phenol (PVP) and epoxy. The gate insulating film 3, the interlayer insulating film 7, and the capacitor insulating film 9 may be formed by vacuum deposition such as sputtering or CVD, or by applying and baking a solution.

Examples of the material of the semiconductor pattern 6 may include inorganic semiconductors such as amorphous Si and poly-Si, organic semiconductors such as polythiophene-based, acene-based, and allylamine-based materials, and oxide semiconductors such as $In_2O_3$-based, $Ga_2O_3$-based, ZnO-based, $SnO_2$-based, InGaZnO-based, InGaSnO-based, and InSnZnO-based materials. The semiconductor pattern 6 may be formed by forming a layer over the insulating substrate 1 by plasma CVD or the like and then performing photolithography, etching, and resist stripping. Alternative methods include printing and baking a solution by using inkjet printing, dispensing, relief printing, or the like. A contact layer for improving electrical contact with the source electrode 4, the drain electrode 5, and the like may be provided above the semiconductor pattern 6. The contact layer above the channel may be removed by etching after formation of the source electrode 4 and the drain electrode 5.

(Second Embodiment)

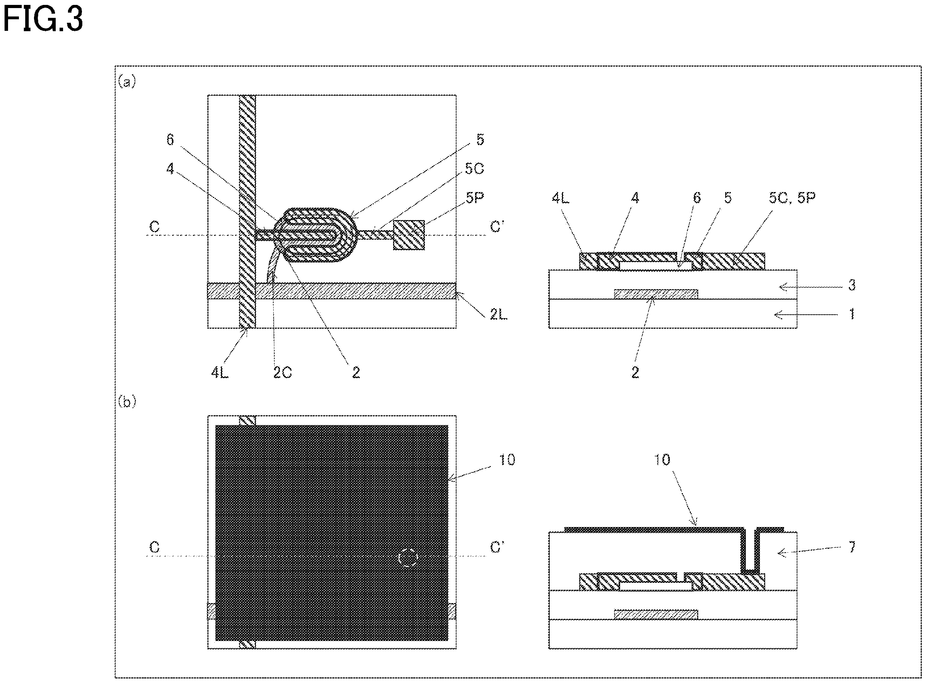

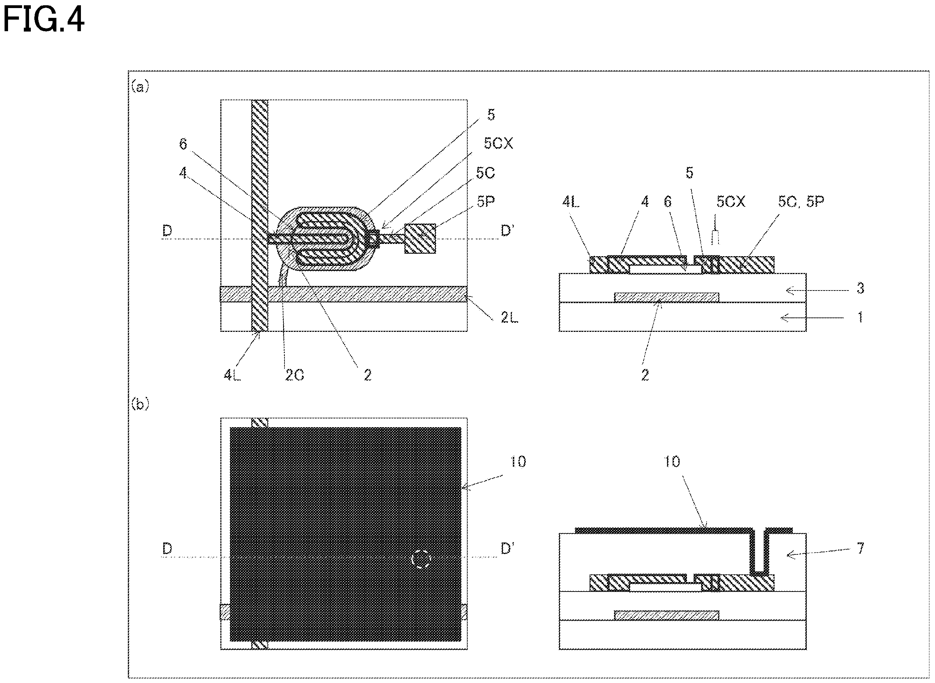

Next, a thin film transistor array according to the second embodiment of the present invention is described, focusing on differences from the thin film transistor array according to the first embodiment. Fig. 3 shows a portion of a thin film transistor array according to the second embodiment of the present invention. Fig. 4 shows a portion of a thin film transistor array according to a variation. In Figs. 3 and 4, (a) is a production drawing for showing features in an easy-to-understand manner, and (b) is a final drawing. The thin film transistor array shown in Figs. 3 and 4 includes a plurality of column wirings 4L extending in the longitudinal direction (first direction), a plurality of row wirings 2L extending in the lateral direction (second direction) orthogonal to the plurality of column wirings 4L, and pixels provided corresponding to crossing points of the column wirings 4L and the row wirings 2L.

In the case of Figs. 3 and 4, a tip of the source electrode 4 is rounded. Furthermore, the bottom of the U shape of the drain electrode 5 is also rounded. With this structure, both side edges and the tip edge of the source electrode 4 can be used to form the channel region 6C, and the area of the source electrode 4 can be reduced while a channel width W for obtaining a required on-state current is sufficiently secured, and an area Sgs of overlap between the gate electrode and the source electrode can be reduced, leading to a reduction in Cgs.

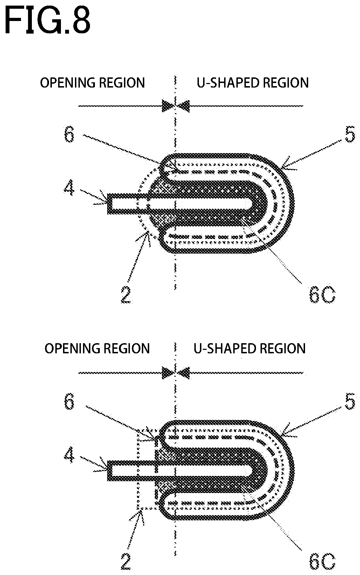

In (a) in Fig. 3, the contour of the gate electrode 2 is smaller than the outer edge 5UO of the drain electrode 5, but is larger than the inner edge 5UI of the drain electrode 5 in the U-shaped region in plan view, as shown in Fig. 8. In other words, at least a portion of the outline of the gate electrode 2 overlaps the U-shaped part 5U of the drain electrode 5 in the U-shaped region in plan view. Since the contour of the gate electrode 2 is smaller than the outer edge 5UO of the drain electrode 5 in the U-shaped region, the area Sgd of overlap between the gate electrode and the drain electrode is small, and the gate-drain capacitance Cgd is also small. Furthermore, since the contour of the gate electrode 2 is larger than the inner edge 5UI of the drain electrode 5, the current in the channel region 6C can be reliably controlled.

In (a) in Fig. 4, the contour of the gate electrode 2 is larger than the outer edge 5UO of the drain electrode 5 in the U-shaped region in plan view. In this case, the drain connecting wiring 5C and the gate electrode 2 have an overlap 5CX, and the gate-drain capacitance Cgd becomes large for the overlap 5CX.

In (a) in Figs. 3 and 4, the contour of the gate electrode 2 is larger than the contour of the semiconductor pattern 6 in the U-shaped region, and the gate electrode 2 and the semiconductor pattern 6 protrude from the opening region in plan view, as shown in Fig. 8. In other words, at least a portion of the outline of the gate electrode 2 is formed outside the outline of the semiconductor pattern 6 in the U-shaped region, and at least a portion of the outline of each of the gate electrode 2 and the semiconductor pattern 6 is formed outside the opening of the U-shaped part 5U in the opening region in plan view. Since the contour of the gate electrode 2 is larger than the contour of the semiconductor pattern 6, incident light from the back side is shielded by the gate electrode 2 and does not reach the semiconductor pattern 6. Accordingly, malfunctions due to external light can be reduced. Particularly, in (a) in Fig. 4, the contour of the gate electrode 2 is larger than that in (a) in Fig. 3, leading to a significant malfunction prevention effect. Furthermore, as a result of the gate electrode 2 and the semiconductor pattern 6 protruding from the opening region, the effect of the parasitic transistor generated from the edge of the semiconductor pattern 6 can be reduced. Note that a portion of the gate electrode 2, the semiconductor pattern 6, or the like that protrudes from the opening region may be round as shown in the upper part of Fig. 8 or may be straight as shown in the lower part of Fig. 8. The channel region 6C is made up of two regions, namely, a main part including the U-shaped region 6U of the channel and an auxiliary part slightly protruding from the opening side.

Note that (b) in Fig. 3 and (b) in Fig. 4 are examples in which there is no storage capacitance. When the display medium has large capacitance, charge is stored in the capacitance of the display medium and the electric potential is maintained, meaning that there is no need to provide storage capacitance inside the TFT array. This is the case, for example, when the display medium is liquid crystals and when the display medium is thin. In contrast, when the capacitance of the display medium is not sufficiently large, the storage capacitance Cs is used.

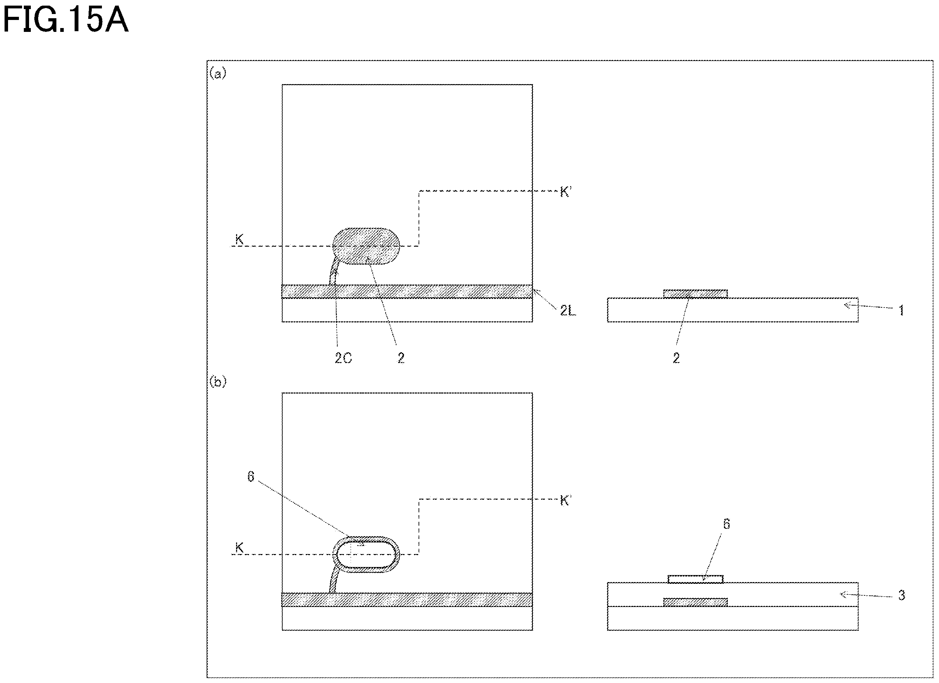

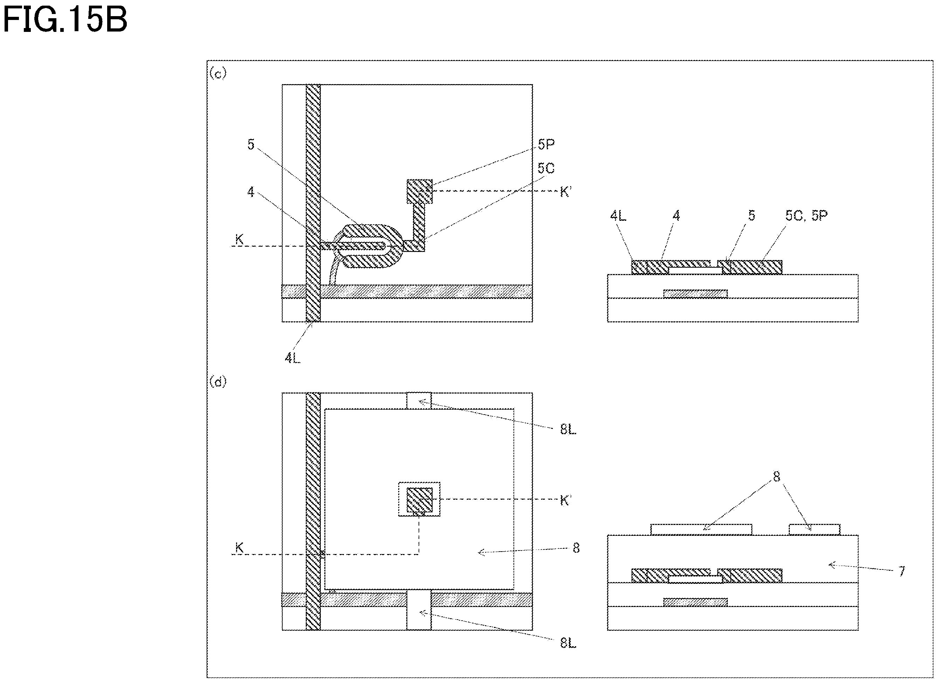

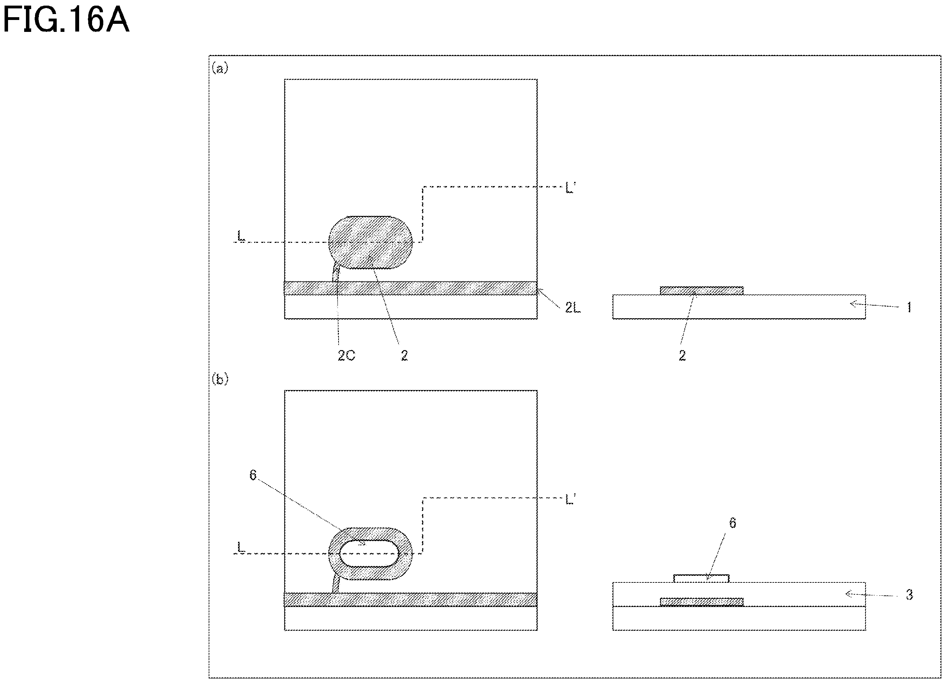

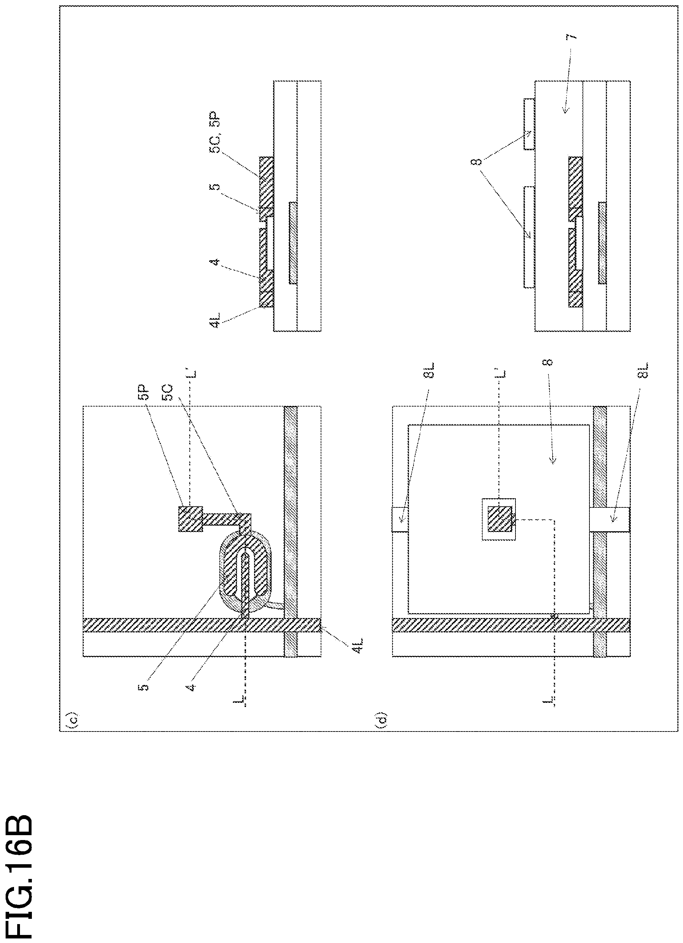

Figs. 15A to 15C show examples of Fig. 3 with the storage capacitance Cs. Figs. 16A to 16C show examples of Fig. 4 with the storage capacitance Cs. Figs. 15A to 15C and Figs. 16A to 16C each show a manufacturing process of a thin film transistor array according to a variation in which a first conductive layer including the gate electrode 2 and the row wiring 2L, the gate insulating layer 3, a second conductive layer including the source electrode 4, the column wiring 4L, and the drain electrode 5, the interlayer insulating film 7, a third conductive layer including the capacitor electrode 8 and the capacitor wiring 8L, the capacitor insulating film 9, and a fourth conductive layer including the pixel electrode 10 are stacked at least in the stated order.

In the thin film transistor arrays shown in Figs. 15A to 15C and Figs. 16A to 16C, the gate-source capacitance Cgs, the source-capacitor capacitance Csc, and the capacitance Csp due to the overlap between the column wiring 4L and the pixel electrode 10 can be reduced for substantially the same reason as in Figs. 10A to 10C.

Possible variations of Fig. 3 include a structure similar to those shown in Figs. 11A to 13B, which are variations of Fig. 1.

Possible variations of Fig. 4 include a structure similar to those shown in Figs. 11A to 13B, which are variations of Fig. 1.

Furthermore, for the reason described above, the structures shown in Figs. 3, 4, and 15A to 16C have the advantageous effect of reducing the amount of electric power consumption.

Note that in the case of (a) in Fig. 3, the width of the U-shaped part 5U of the drain electrode 5 may be, but is not required to be, constant. Although the inner edge 5UI needs to be in a U shape, the outer edge 5UO is not required to be in a U shape. In the case of (a) in Fig. 4, the width of the U-shaped part 5U of the drain electrode 5 should be constant and small. If the outer edge 5UO of the drain electrode 5 is large in (a) in Fig. 4, the area Sgd of overlap between the gate electrode and the drain electrode becomes large, leading to large gate-drain capacitance Cgd.

The widths of the source electrode 4 and the column wiring 4L are substantially the same as those in the thin film transistor array according to the first embodiment.

The thin film transistor array according to the second embodiment can be manufactured using substantially the same materials as those used to manufacture the thin film transistor array according to the first embodiment.


(Third Embodiment)

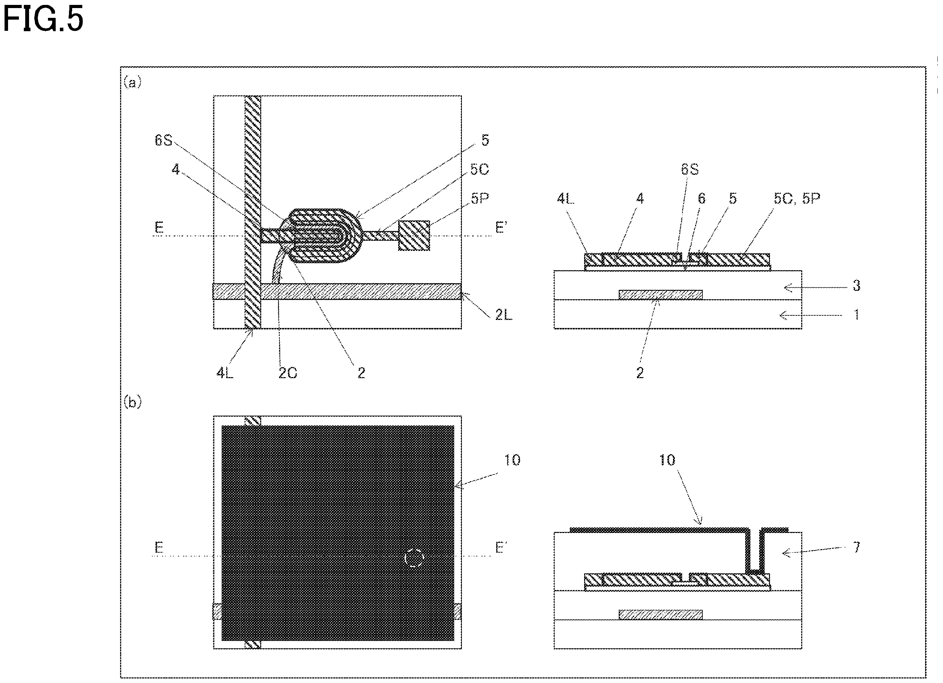

Next, a thin film transistor array according to the third embodiment of the present invention is described, focusing on differences from the thin film transistor array according to the first embodiment. Fig. 5 shows a portion of the thin film transistor array according to the third embodiment of the present invention. In Fig. 5, (a) is a manufacturing process diagram for showing features in an easy-to-understand manner, and (b) is a final drawing. The thin film transistor array shown in Fig. 5 includes a plurality of column wirings 4L extending in the longitudinal direction (first direction), a plurality of row wirings 2L extending in the lateral direction (second direction) orthogonal to the plurality of column wirings 4L, and pixels provided corresponding to crossing points of the column wirings 4L and the row wirings 2L.

Each pixel includes at least a thin film transistor and a pixel electrode 10. The thin film transistor includes a gate electrode 2, a source electrode 4, and a drain electrode 5. In a plan view, the source electrode 4 is in the shape of a line having a rounded tip and a constant width, the drain electrode 5 includes a U-shaped part 5U in a U shape surrounding the source electrode 4 with a gap having a predetermined width therebetween, and at least a portion of a semiconductor pattern 6 connects the source electrode 4 and the drain electrode 5 to form a channel region 6C. At this time, a U-shaped insulative etching stopper layer 6S is formed on the semiconductor pattern 6 to include the gap having the predetermined width, and the semiconductor pattern 6 becomes the channel region 6C below the etching stopper layer 6C and below the source electrode 4 and the drain electrode 5. The gate electrode 2 at least partially overlaps the channel region 6C via a gate insulating film 3, the source electrode 4 is connected to the column wiring 4L, the gate electrode 2 is connected to the row wiring 2L via a gate connecting wiring 2C, and the drain electrode 5 is connected to the pixel electrode 10 via at least a drain connecting wiring 5C. Note that as with the outer edge 5UO and the inner edge 5UI of the U-shaped part 5U of the drain electrode 5 shown in Fig. 6, the outer line and the inner line of the U shape of the etching stopper layer 6S are referred to as an outer edge 6SO and an inner edge 6SI, respectively.

With this structure, the inner edge 6SI of the etching stopper layer 6S that is close to the both side edges and the tip edge of the source electrode 4 can be used to form the channel region 6C, the area of the source electrode 4 can be reduced while the channel width W for obtaining a required on-state current is sufficiently secured, and the area Sgs of overlap between the gate electrode and the source electrode can be reduced, leading to a reduction in Cgs.

The gate connecting wiring 2C is narrower than the gate electrode 2 and overlaps neither of one of the drain electrodes 5 nor the drain connecting wiring 5C. Thus, gate-drain capacitance Cgd can be minimized.

In (a) in Fig. 5, the contour of the gate electrode 2 is smaller than the outer edge 5UO of the drain electrode 5, but is larger than the outer edge 6SO of the etching stopper layer 6S in the U-shaped region in plan view, as shown in Fig. 9. In other words, at least a portion of the outline of the gate electrode 2 is formed outside the outer edge 6SO of the etching stopper layer 6S and overlaps the U-shaped part 5U of the drain electrode 5 in the U-shaped region in plan view. Since the contour of the gate electrode 2 is smaller than the outer edge 5UO of the drain electrode 5 in the U-shaped region, the area Sgd of overlap between the gate electrode and the drain electrode is small, and the gate-drain capacitance Cgd is also small. Furthermore, since the contour of the gate electrode 2 is larger than the outer edge 6SO of the etching stopper layer 6S, the gate electrode 2 includes the etching stopper layer 6 in plan view, and thus the electric current in the channel region 6C can be reliably controlled.

Note that (b) in Fig. 5 is an example in which there is no storage capacitance. When the display medium has large capacitance, charge is stored in the capacitance of the display medium and the electric potential is maintained, meaning that there is no need to provide storage capacitance inside the TFT array. This is the case, for example, when the display medium is liquid crystals and when the display medium is thin. In contrast, when the capacitance of the display medium is not sufficiently large, the storage capacitance Cs is used.

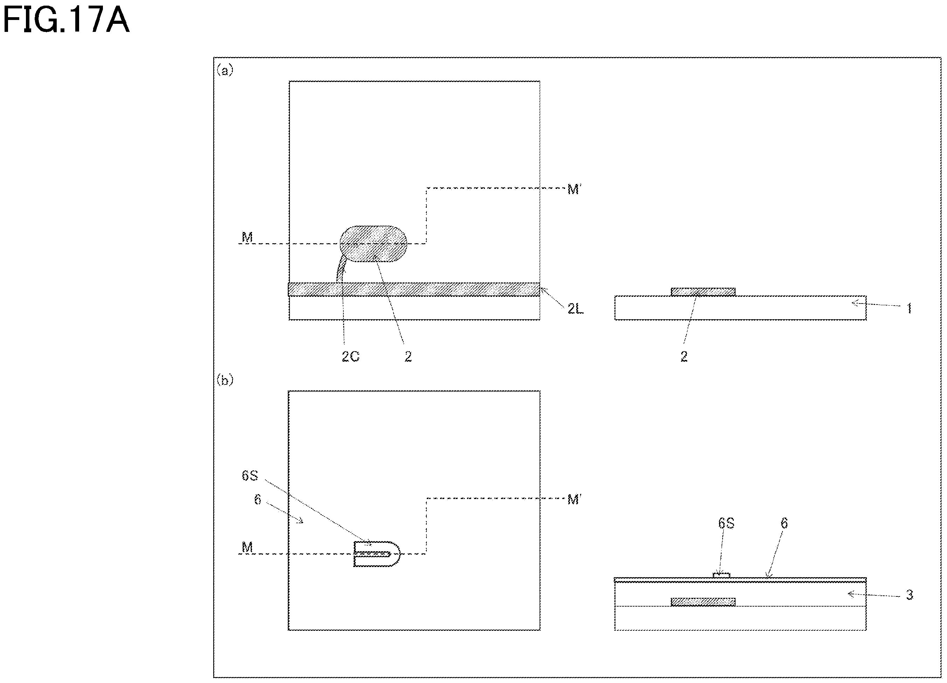

Figs. 17A to 17C show examples in which there is the storage capacitance Cs. Figs. 17A to 17C show the TFT in a manufacturing process of a thin film transistor array according to a variation in which a first conductive layer including the gate electrode 2 and the row wiring 2L, the gate insulating layer 3, a second conductive layer including the source electrode 4, the column wiring 4L, and the drain electrode 5, the interlayer insulating film 7, a third conductive layer including the capacitor electrode 8 and the capacitor wiring 8L, the capacitor insulating film 9, and a fourth conductive layer including the pixel electrode 10 are stacked at least in the stated order.

In the manufactured thin film transistor array, the etching stopper layer 6S in the U shape is formed on the semiconductor pattern 6, the semiconductor pattern 6 contacts the source electrode 4 inside the inner edge 6SI of the etching stopper layer 6S and contacts the drain electrode 5 outside the outer edge 6SO of the U shape of the etching stopper layer 6S in plan view, and the semiconductor pattern 6 immediately below the etching stopper layer 6S forms the U-shaped region 6U of the channel. In plan view, the source electrode 4 is in the shape of a line having a constant width, and because the inner edge 6SI of the etching stopper layer 6S needs to be located inside the source electrode 4, the width of the source electrode 4 cannot be reduced almost to the limit of resolution, but can be reduced to some extent. Therefore, as a result of the area of the source electrode 4 being small, the area Sgs of overlap between the gate electrode 2 and the source electrode 4 is small, and the gate-source capacitance Cgs is small. When the dielectric constant of the gate insulating film 3 is denoted as $\varepsilon$gi and the thickness of the gate insulating film 3 is denoted as Dgi, Cgs = $\varepsilon$gi·Sgs/Dgi. Note that the area Sgsl of overlap between the row wiring 2L and the column wiring 4L cannot be ignored and should be added, resulting in Cgs = sgi·(Sgs + Sgsl)/Dgi.

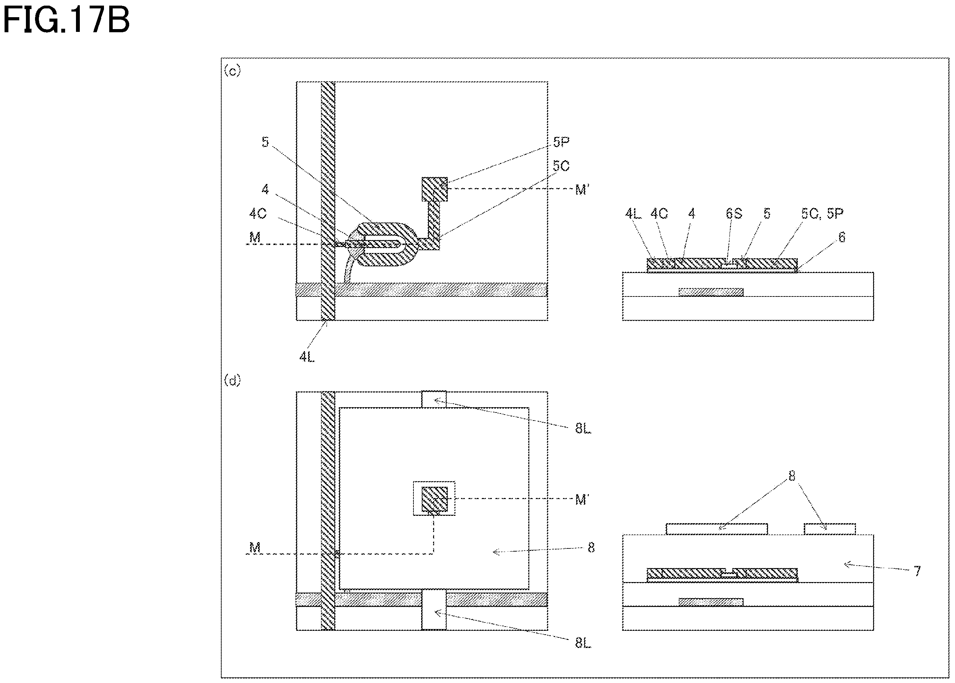

The column wiring 4L overlaps neither of the capacitor electrode 8 nor the capacitor wiring 8L in the plan view. Removing the overlap between the column wiring 4L and the capacitor electrode 8 can lead to a reduction in the source-capacitor capacitance Csc. When the TFT is covered by the capacitor electrode 8, since the source electrode 4 is narrow to some extent, the area of the source electrode 4 is small, and thus the area Ssc of overlap between the source electrode 4 and the capacitor electrode 8 is small, leading to small source-capacitor capacitance Csc. When the dielectric constant of the interlayer insulating film 7 is denoted as $\varepsilon$il and the thickness of the interlayer insulating film 7 is denoted as Dil, Csc = $\varepsilon$il·Ssc/Dil. (When the TFT is not covered by the capacitor electrode 8 as a variation of (d) in Fig. 17B, the area Ssc of overlap between the source electrode 4 and the capacitor electrode 8 is substantially zero, and the source-capacitor capacitance Csc is substantially zero.)

The pixel electrode 10 belongs to a layer different from a layer including the drain electrode 5, and there are the capacitor insulating film 9 and the interlayer insulating film 7 between the pixel electrode 10 and the drain electrode 5; thus, the drain electrode 5 is connected to the pixel electrode 10 via the drain connecting wiring 5C, a drain pad 5P, the opening of the interlayer insulating film 7, and the opening of the capacitor insulating film 9. A major part of the column wiring 4L desirably overlaps the pixel electrode 10 in plan view. When a major part of the column wiring 4L overlaps the pixel electrode 10, the electric potential at the column wiring 4L has no impact on the color of the display medium. Although capacitance Csp due to the overlap between the column wiring 4L and the pixel electrode 10 is generated, the capacitance Csp is not very large because two layers, the capacitor insulating film 9 and the interlayer insulating film 7, are sandwiched. When the dielectric constant of the capacitor insulating film 9 is denoted as $\varepsilon ci$ and the thickness of the capacitor insulating film 9 is denoted as Dci, Csp = Ssp/(Dci/$\varepsilon ci$ + Dil/$\varepsilon il$).

Possible variations of Fig. 5 include a structure similar to those shown in Figs. 11A to 13B, which are variations of Fig. 1.

Furthermore, for the reason described in the first embodiment, the structures shown in Figs. 5 and 17A to 17C have the advantageous effect of reducing the amount of electric power consumption.

Note that in the case of (a) in Fig. 5, the width of the U-shaped part 5U of the drain electrode 5 may be, but is not required to be, constant. Although the inner edge 5UI needs to be in a U shape, the outer edge 5UO is not required to be in a U shape. Furthermore, the width of the etching stopper layer 6S may be, but is not required to be, constant.

The widths of the source electrode 4 and the column wiring 4L are substantially the same as those in the thin film transistor array according to the first embodiment.

The thin film transistor array according to the third embodiment can be manufactured using substantially the same materials as those used to manufacture the thin film transistor array according to the first embodiment.

Examples

(Example 1)

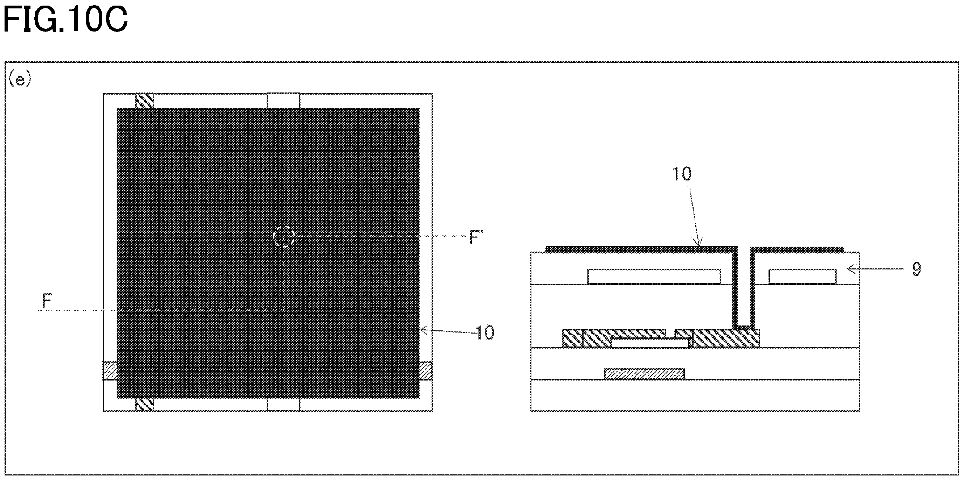

A TFT array as shown in (a) in Fig. 10A to (e) in Fig. 10C was produced. As the first conductive layer, Mo was deposited on the insulating substrate (glass substrate) 1 by sputtering, and the gate electrode 2 and the row wiring 2L were formed by photoresist coating, Mo etching, and resist stripping ((a) in Fig. 10A). Next, SiN was deposited as the gate insulating film 3, amorphous Si was deposited as the semiconductor, n+amorphous Si was deposited as the contact layer, and the semiconductor pattern 6 was formed by resist coating, Si etching, and resist stripping ((b) in Fig. 10A). Furthermore, Mo was deposited as the second conductive layer, the source electrode 4, the column wiring 4L, the drain electrode 5, the drain connecting wiring 5C, and the drain pad 5P were formed by resist coating, Mo etching, and resist stripping, and the contact layer on the channel region 6C was removed by short-period Si etching ((c) in Fig. 10B).

SiN was deposited as the interlayer insulating film 7, Mo was deposited as the third conductive layer, and the capacitor electrode 8 and the capacitor wiring 8L were formed by resist coating, Mo etching, and resist stripping ((d) in Fig. 10B). Next, SiN was deposited as the capacitor insulating film 9, an opening was formed in the capacitor insulating film 9 and the interlayer insulating film 7 by resist coating, SiN etching, and resist stripping, and then Mo was deposited as the fourth conductive layer, and the pixel electrode 10 was formed by resist coating, Mo etching, and resist stripping ((e) in Fig. 10C).

The area Sgs of overlap between the gate electrode and the source electrode was 126 $\mu m^2$, the area Ssc of overlap between the source electrode and the capacitor electrode was 166 $\mu m^2$, the area Ssp of overlap between the column wiring and the pixel electrode was 1016 $\mu m^2$, the thickness Dgi of the gate insulating film 3 was 0.5 $\mu m$, the thickness Dil of the interlayer insulating film 7 was 1 $\mu m$, the thickness Dci of the capacitor insulating film 9 was 0.5 $\mu m$, and the relative dielectric constant of SiN is 7. Thus, Cgs = 16 fF, Csc = 10 fF, and Csp = 42 fF. When the number of columns M = 640, the number of rows N = 480, and Vs = 15 V, the amount of electric power consumed by the column wirings was 4.5 mJ per frame.

(Example 2)

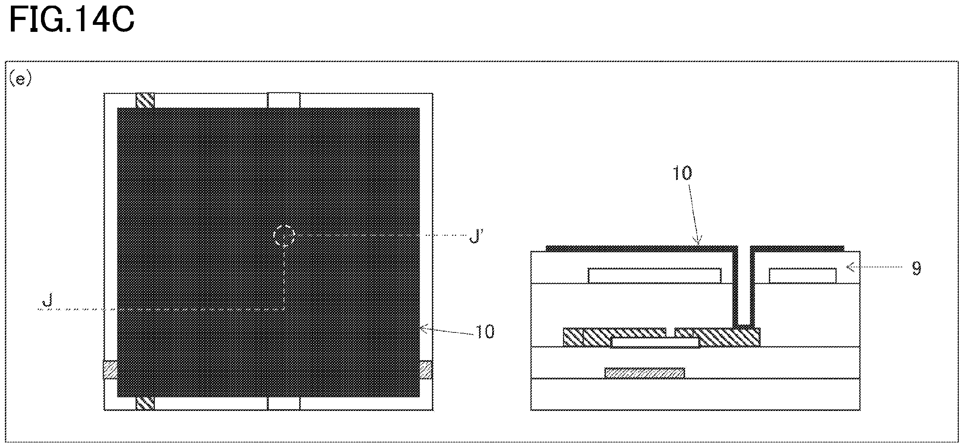

A TFT array shown in (a) in Fig. 14A to (e) in Fig. 14C was produced. The method and material used to form each part were the same as those in Example 1.

The area Sgs of overlap between the gate electrode and the source electrode was 126 $\mu m^2$, the area Ssc of overlap between the source electrode and the capacitor electrode was 166 $\mu m^2$, the area Ssp of overlap between the column wiring and the pixel electrode was 1016 $\mu m^2$, the thickness Dgi of the gate insulating film 3 was 0.5 $\mu m$, the thickness Dil of the interlayer insulating film 7 was 1 $\mu m$, the thickness Dci of the capacitor insulating film 9 was 0.5 $\mu m$, and the relative dielectric constant of SiN is 7. Thus, Cgs = 16 fF, Csc = 10 fF, and Csp = 42 fF. When the number of columns M = 640, the number of rows N = 480, and Vs = 15 V, the amount of electric power consumed by the column wirings was 4.5 mJ per frame.

(Example 3)

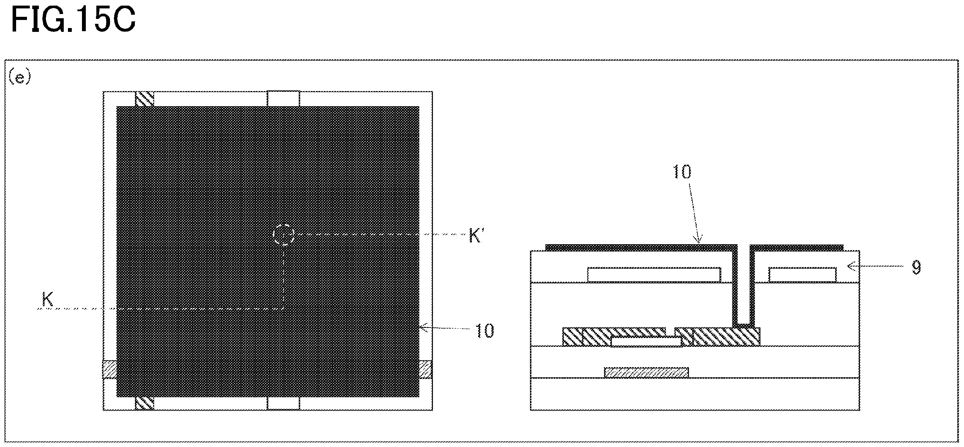

A TFT array shown in (a) in Fig. 15A to (e) in Fig. 15C was produced. The method and material used to form each part were the same as those in Example 1.

The area Sgs of overlap between the gate electrode and the source electrode was 142 $\mu$m$^2$, the area Ssc of overlap between the source electrode and the capacitor electrode was 166 $\mu$m$^2$, the area Ssp of overlap between the column wiring and the pixel electrode was 1016 $\mu$m$^2$, the thickness Dgi of the gate insulating film 3 was 0.5 $\mu$m, the thickness Dil of the interlayer insulating film 7 was 1 $\mu$m, the thickness Dci of the capacitor insulating film 9 was 0.5 $\mu$m, and the relative dielectric constant of SiN is 7. Thus, Cgs = 18 fF, Csc = 10 fF, and Csp = 42 fF. When the number of columns M = 640, the number of rows N = 480, and Vs = 15 V, the amount of electric power consumed by the column wirings was 4.6 mJ per frame.

(Example 4)

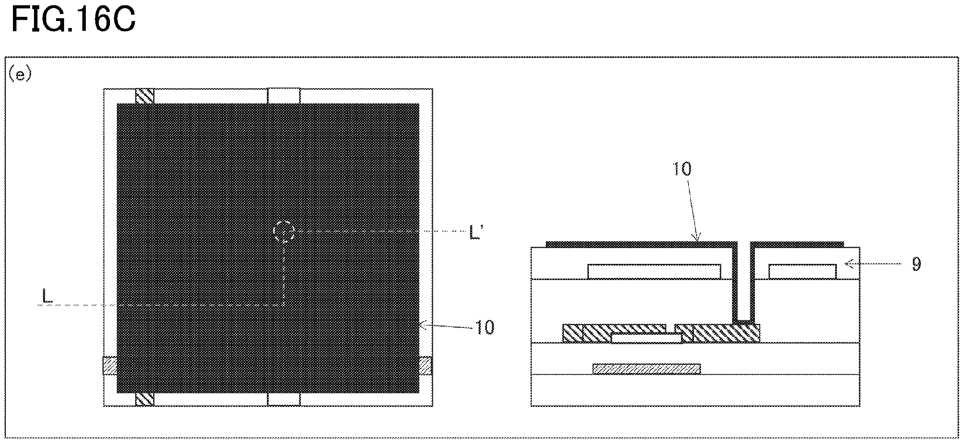

A TFT array shown in (a) in Fig. 16A to (e) in Fig. 16C was produced. The method and material used to form each part were the same as those in Example 1.

The area Sgs of overlap between the gate electrode and the source electrode was 158 $\mu$m$^2$, the area Ssc of overlap between the source electrode and the capacitor electrode was 166 $\mu$m$^2$, the area Ssp of overlap between the column wiring and the pixel electrode was 1016 $\mu$m$^2$, the thickness Dgi of the gate insulating film 3 was 0.5 $\mu$m, the thickness Dil of the interlayer insulating film 7 was 1 $\mu$m, the thickness Dci of the capacitor insulating film 9 was 0.5 $\mu$m, and the relative dielectric constant of SiN is 7. Thus, Cgs = 20 fF, Csc = 10 fF, and Csp = 42 fF. When the number of columns M = 640, the number of rows N = 480, and Vs = 15 V, the amount of electric power consumed by the column wirings was 4.8 mJ per frame.

(Example 5)

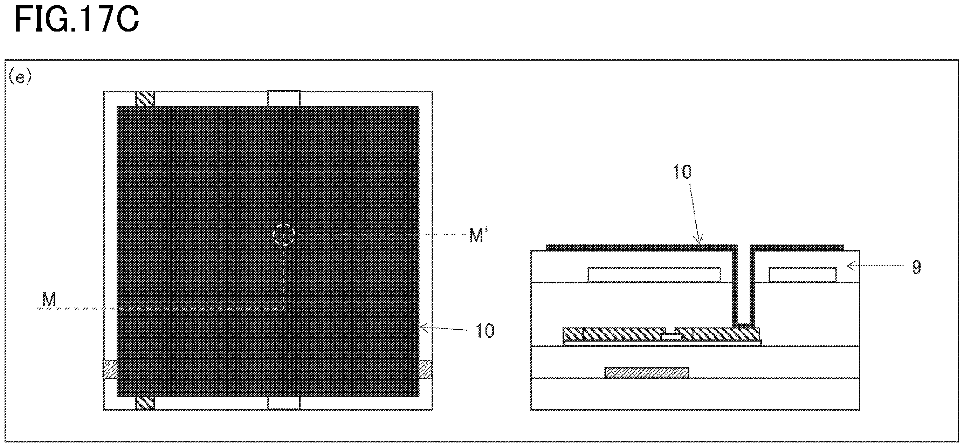

A TFT array shown in (a) in Fig. 17A to (e) in Fig. 17C was produced. As the first conductive layer, Mo was deposited on the insulating substrate (glass substrate) 1 by sputtering, and the gate electrode 2 and the row wiring 2L were formed by photoresist coating, Mo etching, and resist stripping ((a) in Fig. 17A). Next, SiN was deposited as the gate insulating film 3, amorphous Si was deposited as the semiconductor, SiN was deposited as the etching stopper layer, and the etching stopper layer 6C was formed by resist coating, Si etching, and resist stripping ((b) in Fig. 17A). Furthermore, n+ amorphous Si was deposited as the contact layer, Mo was deposited as the second conductive layer, the source electrode 4, the source connecting wiring 4C, the column wiring 4L, the drain electrode 5, the drain connecting wiring 5C, and the drain pad 5P were formed by resist coating, Mo etching, Si etching, and resist stripping, and the semiconductors of the parts other than the etching stopper layer 6S, the source electrode 4, the source connecting wiring 4C, the column wiring 4L, the drain electrode 5, and the drain connecting wiring 5C were removed; thus, the semiconductor pattern 6 was obtained ((c) in Fig. 17B).

The method and material used to form each part after the interlayer insulating film 7 were the same as those in Example 1.

The area Sgs of overlap between the gate electrode and the source electrode was 233 $\mu$m$^2$, the area Ssc of overlap between the source electrode and the capacitor electrode was 273 $\mu$m$^2$, the area Ssp of overlap between the column wiring and the pixel electrode was 1016 $\mu$m$^2$, the thickness Dgi of the gate insulating film 3 was 0.5 $\mu$m, the thickness Dil of the interlayer insulating film 7 was 1 $\mu$m, the thickness Dci of the capacitor insulating film 9 was 0.5 $\mu$m, and the relative dielectric constant of SiN is 7. Thus, Cgs = 29 fF, Csc = 17 fF, and Csp = 42 fF. When the number of columns M = 640, the number of rows N = 480, and Vs = 15 V, the amount of electric power consumed by the column wirings was 5.8 mJ per frame.

In the foregoing cases, each measurement was conducted using examples in which the bottom of the U shape of the drain electrode is round, is in the shape of a semicircle, and is concentric with the rounded tip of the source electrode, and the distance between the source electrode and the drain electrode is substantially constant not only on both sides of the straight part of the source electrode, but also at the tip part of the source electrode. However, as long as the distance between the source electrode and the drain electrode is substantially constant, substantially the same result can be obtained even in the embodiment shown in Figs. 6C to 6E in which at least a portion of the bottom of the U shape of the drain electrode that faces the tip of the source electrode is not round and the tip of the source electrode is rectangular.

(Comparative Example)

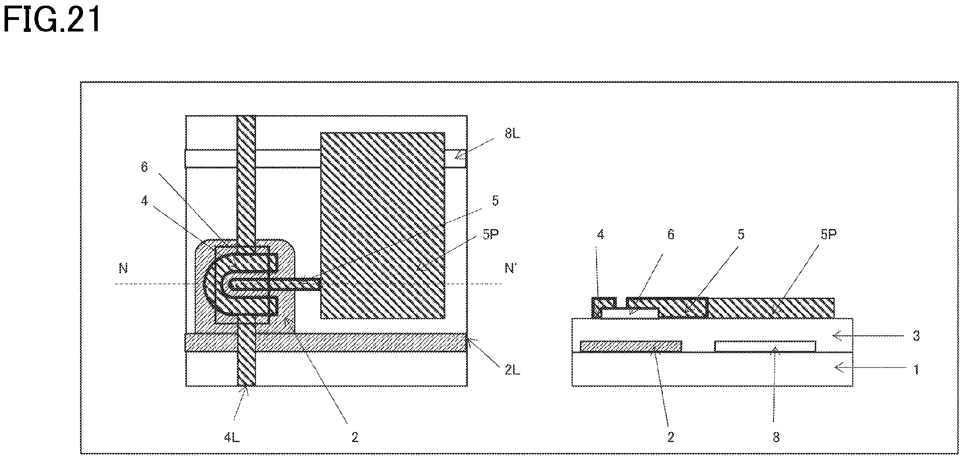

The TFT array shown in Fig. 1 with the drain electrode 5 changed to be linear and the source electrode 4 changed to be in the U shape as in the TFT array shown in Fig. 21 was produced by substantially the same method as in Example 1.

The area Sgs of overlap between the gate electrode and the source electrode was 293 $\mu m^2$, the area Ssc of overlap between the source electrode and the capacitor electrode was 317 $\mu m^2$, the area Ssp of overlap between the column wiring and the pixel electrode was 1016 $\mu m^2$, the thickness Dgi of the gate insulating film 3 was 0.5 $\mu m$, the thickness Dil of the interlayer insulating film 7 was 1 $\mu m$, the thickness Dci of the capacitor insulating film 9 was 0.5 $\mu m$, and the relative dielectric constant of SiN is 7. Thus, Cgs = 36 fF, Csc = 20 fF, and Csp = 42 fF. When the number of columns M = 640, the number of rows N = 480, and Vs = 15 V, the amount of electric power consumed by the column wirings was 6.5 mJ per frame.

[Industrial Applicability]

The present invention can be used in a display device such as electronic paper.

[Reference Signs List]

| | |
|---|---|
| 1 ... | Insulating substrate |
| 2 ... | Gate electrode |
| 2C ... | Gate connecting electrode |
| 2L ... | Row wiring |
| 3 ... | Gate insulating film |
| 4 ... | Source electrode |
| 4C ... | Source connecting electrode |
| 4L ... | Column wiring |
| 5 ... | Drain electrode |
| 5U ... | U-shaped part of drain electrode |
| 5UI ... | Inner edge of drain electrode |
| 5UO ... | Outer edge of drain electrode |
| 5C ... | Drain connecting wiring |
| 5P ... | Drain pad |
| 5S ... | Drain sub-electrode |
| 6 ... | Semiconductor pattern |
| 6C ... | Channel |
| 6U ... | U-shaped region of channel |
| 6S ... | Etching stopper layer |
| 6SI ... | Inner edge of etching stopper layer |
| 6SO ... | Outer edge of etching stopper layer |
| 7 ... | Interlayer insulating film |
| 8 ... | Capacitor electrode |
| 8L ... | Capacitor wiring |
| 9 ... | Capacitor insulating film |
| 10 ... | Pixel electrode |

**Claims**

1. A thin film transistor array comprising:

an insulating substrate;
a plurality of column wirings and a plurality of row wirings above the insulating substrate, the plurality of column wirings extending in a first direction, the plurality of row wirings extending in a second direction orthogonal to the first direction; and
a plurality of pixels disposed above the insulating substrate and each including a thin film transistor and a pixel electrode, the plurality of pixels corresponding to crossing points of the plurality of column wirings and the plurality of row wirings, wherein
the thin film transistor includes a gate electrode, a source electrode, a drain electrode, and a semiconductor pattern,
the source electrode is in a shape of a line having a constant width in plan view,
the drain electrode includes a U-shaped part in a U shape surrounding the source electrode with a gap having a predetermined width therebetween in the plan view,
the semiconductor pattern connects at least the source electrode and the drain electrode to form a channel region,
the gate electrode overlaps the channel region via a gate insulating film and includes the channel region in plan view, and
the source electrode is connected to one of the plurality of column wirings, the gate electrode is connected to one of the plurality of row wirings by a gate connecting wiring, and the drain electrode is connected to the pixel electrode by a drain connecting wiring.

2. The thin film transistor array according to claim 1, wherein
the source electrode is in a shape of a line having a rounded tip and a constant width in plan view.

3. The thin film transistor array according to claim 1 or 2, wherein
the gate connecting wiring is formed so as to overlap neither of the drain electrode or the drain connecting wiring in plan view.

4. The thin film transistor array according to any one of claims 1 to 3, wherein
at least a portion of an outline of the gate electrode is formed so as to overlap the U-shaped part of the drain electrode in plan view.

5. The thin film transistor array according to any one of claims 1 to 4, wherein
at least a portion of an outline of the gate electrode is formed outside an opening of the U-shaped part of the drain electrode and overlaps the semiconductor pattern in plan view, and
at least a portion of an outline of the semiconductor pattern is formed inside the outline of the gate electrode.

6. The thin film transistor array according to any one of claims 1 to 4, wherein
at least a portion of an outline of the gate electrode is formed outside an outline of the semiconductor pattern in the plan view, and
at least a portion of the outline of each of the gate electrode and the semiconductor pattern is formed outside an opening of the U-shaped part of the drain electrode.

7. The thin film transistor array according to any one of claims 1 to 4, further comprising:

an etching stopper layer in a layer located above the semiconductor pattern and located below the source electrode and the drain electrode, the etching stopper layer being insulative, wherein
the etching stopper layer is formed in a U shape having a constant width in the plan view so as to include the gap having the predetermined length to define the channel region, and
at least a portion of an outline of the gate electrode is formed outside an outer edge of the etching stopper layer and overlaps the U-shaped part of the drain electrode in plan view.

8. The thin film transistor array according to any one of claims 1 to 7, wherein
the source electrode has a width less than or equal to a width of each of the plurality of column wirings in plan view.

9. The thin film transistor array according to any one of claims 1 to 8, further comprising:

a source connecting wiring which connects the source electrode and one of the plurality of column wirings, wherein
a width of the source connecting wiring is less than a width of the source electrode in plan view.

10. The thin film transistor array according to any one of claims 1 to 9, wherein
each of the plurality of pixels further includes a capacitor electrode,
the capacitor electrode is capable of having capacitance between the capacitor electrode and the pixel electrode, and
the capacitor electrode is connected to a capacitor wiring.

11. The thin film transistor array according to claim 10, comprising, in the stated order:

a layer including the gate electrode and the plurality of row wirings;
the gate insulating film;
a layer including the source electrode, the plurality of column wirings, and the drain electrode;
an interlayer insulating film;
a layer including the capacitor electrode and the capacitor wiring;
a capacitor insulating film; and
a layer including the pixel electrode, wherein
each of the plurality of column wirings overlaps neither of the capacitor electrode nor the capacitor wiring in the plan view.

12. The thin film transistor array according to claim 10, comprising, in the stated order:

a layer including the source electrode, the plurality of column wirings, and the drain electrode;
the gate insulating film;
a layer including the gate electrode and the plurality of row wirings;
an interlayer insulating film;
a layer including the capacitor electrode and the capacitor wiring;
a capacitor insulating film; and
a layer including the pixel electrode, wherein
each of the plurality of column wirings overlaps neither of the capacitor electrode nor the capacitor wiring in the plan view.

# FIG.1

EP 3 846 225 A1

# FIG.2

FIG.3

# FIG.4

FIG.5

EP 3 846 225 A1

## FIG.6A

OPENING REGION | U-SHAPED REGION

5
5U
4
5T
6U

## FIG.6B

U-SHAPED REGION

5U
5UO    5UI

## FIG.6C

OPENING REGION | U-SHAPED REGION

5
4
5U
6U
5T

## FIG.6D

U-SHAPED REGION

5U

5UO    5UI

## FIG.6E

OPENING REGION    U-SHAPED REGION

5

4

5U

6U

5T

## FIG.6F

U-SHAPED REGION

5U

5UO    5UI

# FIG.7A

OPENING REGION | U-SHAPED REGION

6
5
4
2
6C

OPENING REGION | U-SHAPED REGION

6
5
4
2
6C

# FIG.7B

# FIG.8

OPENING REGION | U-SHAPED REGION

OPENING REGION | U-SHAPED REGION

# FIG.9

OPENING REGION    U-SHAPED REGION

4
5
5U
6U
5T
4L

OPENING REGION    U-SHAPED REGION

4C
4
5
5U
6U
5T
4L

# FIG.10A

FIG.10B

# FIG.10C

(e)

EP 3 846 225 A1

FIG.11A

EP 3 846 225 A1

# FIG.11B

EP 3 846 225 A1

# FIG.11C

35

# FIG.12A

FIG.12B

EP 3 846 225 A1

# FIG.13A

# FIG.13B

# FIG.14A

# FIG.14B

# FIG.14C

(e)

FIG.15A

EP 3 846 225 A1

FIG.15B

# FIG.15C

(e)

FIG.16A

EP 3 846 225 A1

# FIG.16B

# FIG.16C

EP 3 846 225 A1

(e)

L

L'

10

10

10

9

# FIG.17A

FIG.17B

EP 3 846 225 A1

# FIG.17C

# FIG.18

Row Number 1 2 3 4 ⋯ N

V4

$V_p = V_s$
$V_0 = 0$
$V_n = -V_s$

Ip 0 (1) (3) (3)

$I_0$ 0 (4)

In 0
(2) (2) (2)

(1) $I_p = (V_p - V_0)/R * \exp(-t/CR) = V_s/R * \exp(-t/CR)$

(2) $I_n = (V_n - V_p)/R * \exp(-t/CR) = -2V_s/R * \exp(-t/CR)$

(3) $I_p = (V_p - V_n)/R * \exp(-t/CR) = 2V_s/R * \exp(-t/CR)$

(4) $I_0 = (V_0 - V_n)/R * \exp(-t/CR) = V_s/R * \exp(-t/CR)$

$P_p = V_p \cdot I_p$ 0 [1] [3] [3]

$P_0 = V_0 \cdot I_0$ 0 [4]

$P_n = V_n \cdot I_n$ 0 [2] [2] [2]

[1] $\int P_p \, dt = \int_0^\infty V_p \cdot I_p \, dt = CV_s^2 \longrightarrow$ ①+③ $\times (N/2-1) = (N-1)CV_s^2$ total:

[2] $\int P_n \, dt = \int_0^\infty V_n \cdot I_n \, dt = 2CV_s^2$ ④=0

[3] $\int P_p \, dt = \int_0^\infty V_p \cdot I_p \, dt = 2CV_s^2$ ② $\times N/2 = NCV_s^2$ $(2N-1)CV_s^2$

[4] $\int P_0 \, dt = \int_0^\infty V_0 \cdot I_0 \, dt = 0$

EP 3 846 225 A1

# FIG.19

Row Number    1   2   3   4   ⋯   N

V2

Vp

Vn

Ip    0    (6)

In    0    (5)

$Pp = Vp \cdot Ip$    0    [6]

$Pn = Vn \cdot In$    0    [5]

(5)   $In = -(Vp-Vn)/R * \exp(-t/CR)$

(6)   $Ip = (Vp-Vn)/R * \exp(-t/CR)$

[5]   $\int Pn \; dt = \int_0^\infty Vn \cdot In \; dt = -CVn(Vp-Vn)$  ⎤ total:

[6]   $\int Pp \; dt = \int_0^\infty Vp \cdot Ip \; dt = CVp(Vp-Vn)$  ⎦ $C(Vp-Vn)^2 = C(\Delta Vg)^2$

EP 3 846 225 A1

# FIG.20

Row Number     1   2   3   4   ⋯   N

Vpixel

$V_s$   Vgf

0

$V_s \rightarrow V_d$

$V_s$

HiZ

Itft    0   (7)

(7)   $I_{tft} = V_s / R_{tft} * \exp(-t/CR)$

total:

$P_{tft} = V_d \cdot I_{tft}$   0   [7]

[7]   $\int P_{tft}\, dt = \int_0^\infty V_d \cdot I_{tft}\, dt = CV_s^2$   $CV_s^2$

t

EP 3 846 225 A1

FIG.21

**INTERNATIONAL SEARCH REPORT**

International application No.

PCT/JP2019/033100

A. CLASSIFICATION OF SUBJECT MATTER
Int.Cl. H01L29/786(2006.01)i, G09F9/30(2006.01)i, H01L21/3205(2006.01)i,
H01L21/336(2006.01)i, H01L21/768(2006.01)i, H01L23/522(2006.01)i

According to International Patent Classification (IPC) or to both national classification and IPC

B. FIELDS SEARCHED

Minimum documentation searched (classification system followed by classification symbols)
Int.Cl. H01L29/786, G09F9/30, H01L21/3205, H01L21/336, H01L21/768,
H01L23/522

Documentation searched other than minimum documentation to the extent that such documents are included in the fields searched
Published examined utility model applications of Japan 1922–1996
Published unexamined utility model applications of Japan 1971–2019
Registered utility model specifications of Japan 1996–2019
Published registered utility model applications of Japan 1994–2019

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | US 8045079 B2 (JUNG, Kwang-Chul) 25 October 2011, entire text, all drawings & US 2009/0135358 A1 & KR 10-2009-0054572 A | 1-12 |
| A | US 2015/0129882 A1 (BOE TECHNOLOGY GROUP CO., LTD.) 14 May 2015, entire text, all drawings & WO 2015/010431 A1 & CN 103412449 A | 1-12 |

☒ Further documents are listed in the continuation of Box C.     ☐ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

Date of the actual completion of the international search
13 September 2019 (13.09.2019)

Date of mailing of the international search report
24 September 2019 (24.09.2019)

Name and mailing address of the ISA/
Japan Patent Office
3-4-3, Kasumigaseki, Chiyoda-ku,
Tokyo 100-8915, Japan

Authorized officer

Telephone No.

Form PCT/ISA/210 (second sheet) (January 2015)

**INTERNATIONAL SEARCH REPORT**

| International application No. |
| --- |
| PCT/JP2019/033100 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | WO 2016/195039 A1 (SHARP CORP.) 08 December 2016, entire text, all drawings (Family: none) | 1-12 |
| A | US 2010/0320473 A1 (LIU, Chihchung) 23 December 2010, entire text, all drawings & WO 2010/078743 A1 & CN 101707211 A & TW 201100939 A | 1-12 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014187093 A

- JP 2003233786 A